# EUROPEAN PATENT APPLICATION

(11) **EP 4 727 306 A1**
(43) Date of publication of application: **15.04.2026**
(21) Application number: 25195220.6
(22) Date of filing: 11.08.2025
(51) Int. Cl.: H10H 29/01, H10H 29/80, H10H 29/34, H10H 29/37, H10H 29/39, H10H 29/41, H10H 29/49, H10H 29/855

(54) **LIGHT-EMITTING DEVICE, DISPLAY APPARATUS INCLUDING THE SAME, AND METHOD OF MANUFACTURING THE SAME**

(30) Priority: 08.10.2024 KR 20240136824
(71) Applicant: Samsung Electronics Co., Ltd., Suwon-si, Gyeonggi-do 16677 (KR)
(72) Inventor: Hwang, Kyungwook, 16677 Suwon-si (KR); Hwang, Junsik, 16678 Suwon-si (KR); Kim, Joosung, 16678 Suwon-si (KR); Shin, Dongchul, 16677 Suwon-si (KR); Song, Sanghoon, 16678 Suwon-si (KR); Oh, Youngtek, 16677 Suwon-si (KR)
(74) Representative: Arnold & Siedsma

(57) **Abstract**

Provided is a display apparatus including a light-emitting structure in which a first light-emitting element, a second light-emitting element, and a third light-emitting element, a first electrode pattern electrically connected to a p-type semiconductor layer of the first light-emitting element, a p-type semiconductor layer of the second light-emitting element, and a p-type semiconductor layer of the third light-emitting element, and a second electrode pattern electrically connected to a n-type semiconductor layer of the first light-emitting element, a n-type semiconductor layer of the second light-emitting element, and a n-type semiconductor layer of the third light-emitting element.

## Description

### BACKGROUND

### 1. Field

Embodiments of the present disclosure relate to a light-emitting device, a display apparatus including the light-emitting device, and a method of manufacturing the light-emitting device.

### 2. Description of Related Art

Light-emitting diodes (LEDs) are known as the next-generation light sources due to their advantages such as relatively long lifespan, low power consumption, fast response speed, and environmental friendliness compared to conventional light sources. Because of these advantages, the industrial demand for LEDs is increasing. LEDs have been generally applied and used in various products such as lighting devices and backlights of display apparatuses. Recently, micro units of micro-LEDs using group II-VI or group III-V compound semiconductors have been developed.

In addition, micro-LED displays including micro-LEDs directly used as light-emitting devices of display pixels have been developed. A method of manufacturing a light-emitting element for each sub-pixel and a method of manufacturing a light-emitting element for each pixel have been researched.

### SUMMARY

One or more embodiments provide a monolithic light-emitting device having an epitaxial structure in which a plurality of light-emitting elements emitting light of different wavelengths are vertically stacked, a display apparatus including the monolithic light-emitting device, and a method of manufacturing the monolithic light-emitting device.

One or more embodiments also provide a monolithic light-emitting device in which the active areas of active layers are evenly distributed, a display apparatus including the monolithic light-emitting device, and a method of manufacturing the same.

Additional aspects will be set forth in part in the description which follows and, in part, will be apparent from the description, or may be learned by practice of one or more embodiments.

According to an aspect of one or more embodiments, there is provided a display apparatus including a display layer including a plurality of light-emitting elements, and a driving layer configured to drive the plurality of light-emitting elements, wherein at least one light-emitting element of the plurality of light-emitting elements includes a first insulating layer, a light-emitting structure including a first light-emitting element, a second light-emitting element, and a third light-emitting element sequentially and monolithically on the first insulating layer, each of the first light-emitting element, the second light-emitting element, and the third light-emitting element including a p-type semiconductor layer, an active layer, and an n-type semiconductor layer and being configured to emit light of different wavelengths, a first electrode pattern including a first electrode, a second electrode, and a third electrode electrically connected to the p-type semiconductor layer of the first light-emitting element, the p-type semiconductor layer of the second light-emitting element, and the p-type semiconductor layer of the third light-emitting element, respectively, and the first electrode, the second electrode, and the third electrode being exposed on a surface of the first insulating layer, and a second electrode pattern including a fourth electrode, a fifth electrode, and a sixth electrode electrically connected to the n-type semiconductor layer of the first light-emitting element, the n-type semiconductor layer of the second light-emitting element, and the n-type semiconductor layer of the third light-emitting element, respectively, and the fourth electrode, the fifth electrode, and the sixth electrode being exposed on a surface of the third light-emitting element.

By doing so, the light-emitting structure of the display apparatus is implemented as a structure in which the first light-emitting element emitting light of a first wavelength, the second light-emitting element emitting light of a second wavelength different from the first wavelength, and the third light-emitting element emitting light of a third wavelength different from the first wavelength and the second wavelength are stacked in the vertical direction (Z direction) of the light-emitting structure. For example, the first light-emitting element may emit red light, the second light-emitting element may emit green light, and the third light-emitting element may emit blue light. As will be described below, the light-emitting structure may be formed by sequentially monolithically growing (forming) the third light-emitting element, the second light-emitting element, and the first light-emitting element on one sacrificial layer SCL. Thus, the light-emitting structure may not include a bonding material for coupling neighboring and adjacent light-emitting elements among the first light-emitting element, the second light-emitting element, and the third light-emitting element.

The first electrode may penetrate the first insulating layer and contact the p-type semiconductor layer of the first light-emitting element, the fourth electrode may penetrate the third light-emitting element and the second light-emitting element and contact the n-type semiconductor layer of the first light-emitting element, and the first light-emitting element may be configured to emit first light based on an electrical signal applied to the first electrode and an electrical signal applied to the fourth electrode.

The second electrode may penetrate the first insulating layer and the first light-emitting element and contact the p-type semiconductor layer of the second light-emitting element, the fifth electrode may penetrate the third light-emitting element and contact the n-type semiconductor layer of the second light-emitting element, and the second light-emitting element may be configured to emit second light based on an electrical signal applied to the second electrode and an electrical signal applied to the fifth electrode.

The third electrode may penetrate the first insulating layer, the first light-emitting element, and the second light-emitting element and contact the p-type semiconductor layer of the third light-emitting element, wherein the sixth electrode may contact a surface of the n-type semiconductor layer of the third light-emitting element, and the third light-emitting element may be configured to emit third light based on an electrical signal applied to the third electrode and an electrical signal applied to the sixth electrode.

The first electrode, the second electrode, and the third electrode may not be electrically connected to each other.

The fourth electrode, the fifth electrode, and the sixth electrode may be electrically connected to each other.

The sixth electrode may be on the surface of the third light-emitting element and contact the fourth electrode and the fifth electrode.

The light-emitting structure may not include a bonding material.

In each of the first light-emitting element, the second light-emitting element, and the third light-emitting element, the p-type semiconductor layer, the active layer, and the n-type semiconductor layer may be sequentially on the driving layer.

A wavelength of light emitted by the first light-emitting element may be greater than a wavelength of light emitted by the second light-emitting element, and the wavelength of light emitted by the second light-emitting element may be greater than a wavelength of light emitted by the third light-emitting element.

The display apparatus may further include an optical layer on the display layer, the optical layer being configured to control a traveling path of light emitted from the display layer.

The optical layer may include a plurality of microlenses corresponding to the plurality of light-emitting elements on a one-to-one basis.

The display layer may include a first light-emitting device and a second light-emitting device adjacent to each other, and a pixel partition configured to partition the first light-emitting device and the second light-emitting device.

The pixel partition may be configured to spatially separate p-type semiconductor layers of a first light-emitting element, a second light-emitting element, and a third light-emitting element included in the first light-emitting device and an active layer of the third light-emitting element, and p-type semiconductor layers of a first light-emitting element, a second light-emitting element, and a third light-emitting element included in the second light-emitting device and an active layer of the third light-emitting element.

An n-type semiconductor layer of a third light-emitting element included in the first light-emitting device and an n-type semiconductor layer of a third light-emitting element included in the second light-emitting device may be connected to each other.

A sixth electrode included in the first light-emitting device and a sixth electrode included in the second light-emitting device may be connected to each other and on a same plane.

The display apparatus may further include a reflective layer on at least a partial area of a side surface of the pixel partition and a surface of the first light-emitting element.

The display apparatus may further include a second insulating layer filling at least a part of an inner space of the pixel partition and a space between the display layer and the driving layer, wherein the second insulating layer may include at least one of a black matrix material, a resin, or a polymer.

According to another aspect of one or more embodiments, there is provided a method of manufacturing a display apparatus, the method including forming, on a sacrificial layer, a light-emitting structure including a first light-emitting element, a second light-emitting element, and a third light-emitting element, each of the first light-emitting element, the second light-emitting element, and the third light-emitting element including a p-type semiconductor layer, an active layer, and an n-type semiconductor layer and being configured to emit light of different wavelengths, forming a first insulating layer on the light-emitting structure, forming a first electrode pattern including a first electrode, a second electrode, and a third electrode electrically connected to the p-type semiconductor layer of the first light-emitting element, the p-type semiconductor layer of the second light-emitting element, and the p-type semiconductor layer of the third light-emitting element, respectively, and exposed on a surface of the first insulating layer, bonding the first electrode pattern on a driving layer configured to drive the light-emitting structure, removing the sacrificial layer from the light-emitting structure, and forming a second electrode pattern including a fourth electrode, a fifth electrode, and a sixth electrode electrically connected to the n-type semiconductor layer of the first light-emitting element, the n-type semiconductor layer of the second light-emitting element, and the n-type semiconductor layer of the third light-emitting element, respectively, and exposed on a surface of the third light-emitting element.

The method may further include forming a pixel partition configured to separate the light-emitting structure into a plurality of pixels.

### BRIEF DESCRIPTION OF DRAWINGS

The above and other aspects, features, and advantages of one or more embodiments will be more apparent from the following description taken in conjunction with the accompanying drawings, in which:
FIG. 1 is a cross-sectional view illustrating a light-emitting device according to one or more embodiments;
FIG. 2 is a view illustrating a light-emitting device including first to third light-emitting elements having varying widths according to one or more embodiments;
FIG. 3 is a diagram illustrating a light-emitting device including a first reflective layer according to one or more embodiments;
FIG. 4 is a diagram illustrating a light-emitting device including a fourth insulating layer according to one or more embodiments;
FIG. 5 is a diagram illustrating a light-emitting device including a second reflective layer according to one or more embodiments;
FIG. 6 is a block diagram of a display apparatus including a light-emitting device according to one or more embodiments;
FIG. 7 is a diagram illustrating a portion of a display apparatus including a plurality of light-emitting devices according to one or more embodiments;
FIG. 8 is a diagram illustrating a display apparatus including a pixel partition according to one or more embodiments;
FIG. 9 is a diagram illustrating a display apparatus including an optical layer controlling an optic path according to one or more embodiments;
FIG. 10 is a diagram illustrating a display apparatus to which light-emitting devices are connected according to one or more embodiments;
FIGS. 11, 12, 13, 14, 15, 16, 17, 18, 19, 20, and 21 are reference diagrams for describing a method of manufacturing a display apparatus according to one or more embodiments;
FIG. 22 is a diagram illustrating an example of applying a display apparatus according to one or more embodiments to a mobile device;
FIG. 23 is a diagram illustrating an example of applying a display apparatus according to one or more embodiments to a vehicle;
FIG. 24 is a diagram illustrating an example of applying a display apparatus according to one or more embodiments to augmented reality glasses or virtual reality glasses;
FIG. 25 is a diagram illustrating an example of applying a display apparatus according to one or more embodiments to a large signage; and
FIG. 26 is a diagram illustrating an example of applying a display apparatus according to one or more embodiments to a display of a wearable device.

### DETAILED DESCRIPTION

Reference will now be made in detail to embodiments, examples of which are shown in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, the embodiments will be described in detail with reference to the accompanying drawings. The embodiments described below are merely exemplary, and various modifications are possible from these embodiments. In the following drawings, the same reference numerals refer to the same components, and the size of each component in the drawings may be exaggerated for clarity and convenience of description.

Hereinafter, what is described as "above" or "on" may include those directly on, underneath, left, and right in contact, as well as above, below, left, and right in non-contact.

Terms such as first, second, etc. may be used to describe various components, but are used only for the purpose of distinguishing one component from another component. These terms do not limit the difference in the material or structure of the components.

The terms of a singular form may include plural forms unless otherwise specified. In addition, when a certain part "includes" a certain component, it means that other components may be further included rather than excluding other components unless otherwise stated.

In addition, terms such as "unit" and "module" described in the specification mean a unit that processes at least one function or operation, and this may be implemented as hardware or software, or may be implemented as a combination of hardware and software.

The specific implementations described in the embodiment are examples and are not intended to limit the technical scope in any way. For the sake of brevity of the specification, descriptions of conventional electronic components, control systems, software, and other functional aspects of the systems may be omitted. Connections of lines or connection members between elements shown in the drawings are illustrative of functional connections and/or physical or circuitry connections, and may be replaced in an actual device, or may be represented as additional various functional connections, physical connections, or circuitry connections.

The use of the term "the" and similar designating terms may correspond to both the singular and the plural.

Operations of a method may be performed in an appropriate order unless explicitly described in terms of order. In addition, the use of all illustrative terms (e.g., etc.) is merely for describing technical ideas in detail, and the scope is not limited by these examples or illustrative terms unless limited by the claims.

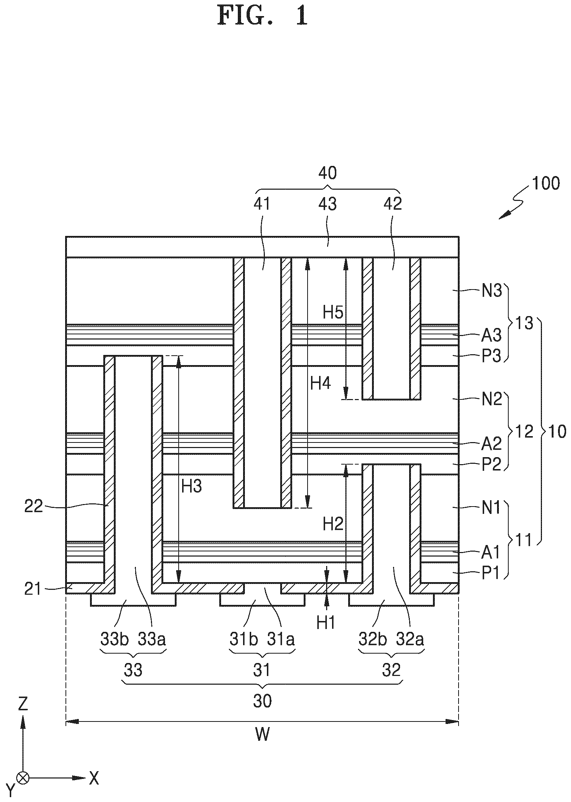

FIG. 1 is a cross-sectional view illustrating a light-emitting device 100 according to one or more embodiments.

Referring to FIG. 1, the light-emitting device 100 according to one or more embodiments may include an inorganic light-emitting diode (LED) and emit light of a specific wavelength according to a material included in the light-emitting device 100. The light-emitting device 100 according to one or more embodiments may have a micro size. For example, a width W of the light-emitting device 100 may be less than or equal to about 50 µm, less than or equal to about 10 µm, less than or equal to about 5 µm, or less than or equal to about 3 µm in a horizontal direction (X direction and/or Y direction).

The light-emitting device 100 according to one or more embodiments may include a light-emitting structure 10 in which a first light-emitting element 11, a second light-emitting element 12, and a third light-emitting element 13, which emit light of different wavelengths, are monolithically stacked. A cross-section parallel to the light-emitting structure 10 in a horizontal direction (X-direction and/or Y-direction), that is, a transverse section, may be circular, elliptical, and/or polygonal. For example, the transverse section of the light-emitting structure 10 may have a rectangular shape. A cross-section parallel to the light-emitting structure 10 in a vertical direction (e.g., a Z direction) may have a rectangular shape. For example, a side cross-section of a body 110 may have a rectangular shape or trapezoidal shape.

The light-emitting structure 10 may be a structure in which the first light-emitting element 11 emitting light of a first wavelength, the second light-emitting element 12 emitting light of a second wavelength different from the first wavelength, and the third light-emitting element 13 emitting light of a third wavelength different from the first wavelength and the second wavelength are stacked in the vertical direction (Z direction) of the light-emitting structure 10. For example, the first light-emitting element 11 may emit red light, the second light-emitting element 12 may emit green light, and the third light-emitting element 13 may emit blue light. As will be described below, the light-emitting structure 10 may be formed by sequentially monolithically growing (forming) the third light-emitting element 13, the second light-emitting element 12, and the first light-emitting element 11 on one sacrificial layer SCL. Thus, the light-emitting structure 10 may not include a bonding material for coupling neighboring and adjacent light-emitting elements among the first light-emitting element 11, the second light-emitting element 12, and the third light-emitting element 13.

The first light-emitting element 11 may include a p-type semiconductor layer P1, an active layer A1 disposed on the p-type semiconductor layer P1, and an n-type semiconductor layer N1 disposed on the active layer A1. The p-type semiconductor layer P1, the active layer A1, and the n-type semiconductor layer N1 may have a vertical stack structure.

The p-type semiconductor layer P1 and the n-type semiconductor layer N1 may include a group II-VI or group III-V compound semiconductor material, in particular a nitride semiconductor material. For example, the p-type semiconductor layer P1 and the n-type semiconductor layer N1 may include at least one nitride semiconductor material among indium aluminum gallium nitride (InAlGaN), gallium nitride (GaN), aluminum gallium nitride (AlGaN), indium gallium nitride (InGaN), aluminum nitride (AlN), and indium nitride (InN). The p-type semiconductor layer P1 and the n-type semiconductor layer N1 may serve to provide electrons and holes to the active layer A1. To this end, the p-type semiconductor layer P1 may be doped with a p-type dopant, and the n-type semiconductor layer N1 may be doped with an n-type dopant electrically different from the p-type dopant. The n-type semiconductor layer N1 may include silicon (Si), germanium (Ge), tin (Sn), etc. as a dopant, and the p-type semiconductor layer P1 may include magnesium (Mg), zinc (Zn), etc. as a dopant. The n-type semiconductor layer N1 may provide electrons to the active layer A1, and the p-type semiconductor layer P1 may provide holes to the active layer A1.

The active layer A1 may be disposed between the p-type semiconductor layer P1 and the n-type semiconductor layer N1. The active layer A1 has a quantum well structure in which a quantum well is disposed between barriers. As electrons and holes provided in the p-type semiconductor layer P1 and the n-type semiconductor layer N1 are recombined in the quantum well in the active layer A1, light may be generated. A wavelength of light generated from the active layer A1 may be determined according to an energy band gap of a material constituting the quantum well in the active layer A1. The active layer A1 may have one quantum well, but may have a multi-quantum well (MQW) structure in which a plurality of quantum wells and a plurality of barriers are alternately disposed. The thickness of the active layer A1 in the vertical direction (Z direction) or the number of quantum wells in the active layer A1 may be appropriately selected in consideration of a voltage applied to the first light-emitting element 11 and light emission efficiency. The active layer A1 may include a group II-VI or group III-V compound semiconductor material, in particular a nitride semiconductor material. For example, the active layer A1 may include at least one nitride semiconductor material among InGaN, GaN, AlGaN, and InAlGaN.

When the active layer A1 includes indium (In), as the indium content decreases a wavelength of light emitted by the active layer A1 may decrease. For example, in the active layer A1 including InGaN or InAlGaN, when the indium content in the nitride semiconductor material is about 35 at%, the active layer A1 may emit red light of about 630 nm, when the indium content is about 30 at%, the active layer A1 may emit yellow light of about 560 nm, and when the indium content is about 25 at%, the active layer A1 may emit green light of about 320 nm. In addition, when the indium content is about 15 at%, the active layer A1 may emit blue light of about 450 nm. For example, the active layer A1 of the first light-emitting element 11 may include an indium content of about 35 at%, and emit red light.

The second light-emitting element 12 may be disposed on the first light-emitting element 11. Like the first light-emitting element 11, the second light-emitting element 12 may include a p-type semiconductor layer P2, an active layer A2, and an n-type semiconductor layer N2, and have a vertical stack structure. The p-type semiconductor layer P2 and the n-type semiconductor layer N2 of the second light-emitting element 12 may be respectively the same as the p-type semiconductor layer P1 and the n-type semiconductor layer N1 of the first light-emitting element 11. For example, the p-type semiconductor layer P2 and the n-type semiconductor layer N2 of the second light-emitting element 12 may include at least one nitride semiconductor material among InAlGaN, GaN, AlGaN, InGaN, AlN, and InN.

The active layer A2 of the second light-emitting element 12 may have a different composition of the nitride semiconductor material from a composition of the nitride semiconductor material of the active layer A1 of the first light-emitting element 11. Thus, the second light-emitting element 12 may emit light of a different wavelength band from the first light-emitting element 11. The active layer A2 of the second light-emitting element 12 may have a lower indium content than an indium content of the active layer A1 of the first light-emitting element 11. For example, the active layer A2 of the second light-emitting element 12 may include about 25 at% indium and emit green light.

The third light-emitting element 13 may be disposed on the second light-emitting element 12. Similar to the first light-emitting element 11 and the second light-emitting element 12, the third light-emitting element 13 may also include a p-type semiconductor layer P3, an active layer A3, and an n-type semiconductor layer N3, and have a vertical stack structure. The p-type semiconductor layer P3 and the n-type semiconductor layer N3 of the third light-emitting element 13 are the same as the p-type semiconductor layer P1 and the n-type semiconductor layer N1 of the first light-emitting element 11, and thus detailed descriptions thereof will be omitted. The active layer A3 of the third light-emitting element 13 may have a different composition of the nitride semiconductor material from that of the active layer A1 of the first light-emitting element 11. For example, the active layer A3 of the third light-emitting element 13 may include an indium content of about 15 at% and emit blue light.

The widths of the first light-emitting element 11, the second light-emitting element 12, and the third light-emitting element 13 may be substantially the same in the horizontal direction (X direction and/or Y direction). Accordingly, the areas of the active layers A1 of the first light-emitting element 11, the second light-emitting element 12, and the third light-emitting element 13 may be substantially the same.

As the size of a light-emitting element decreases, the current density applied to the light-emitting element may increase. When the current density increases, because the external quantum efficiency in the light-emitting element decreases, the light emission efficiency of the light-emitting element may also decrease. In the light-emitting device 100 according to one or more embodiments, because the first light-emitting element 11, the second light-emitting element 12, and the third light-emitting element 13 which emit light of different wavelengths are stacked in a vertical direction, that is, a light emission direction (e.g., the Z direction), the active layers A1, A2, and A3 of relatively wide areas may be secured. The active layers A1, A2, and A3 of relatively wide areas may reduce the current density applied to the first light-emitting element 11, the second light-emitting element 12, and the third light-emitting element 13, and the reduced current density may increase the external quantum efficiency and increase the light emission efficiency of the first light-emitting element 11, the second light-emitting element 12, and the third light-emitting element 13.

The first light-emitting element 11, the second light-emitting element 12, and the third light-emitting element 13 have been described with respect to the minimum configurations necessary for basic operations, but embodiments are not limited thereto. At least one of the first light-emitting element 11, the second light-emitting element 12, and the third light-emitting element 13 may further include various layers for improving performance. For example, a carrier blocking layer and/or stress relief layers may be further disposed between the p-type semiconductor layers P1, P2, and P3 and the active layers A1, A2, and A3, and between the active layers A1, A2, and A3 and the n-type semiconductor layers N1, N2, and N3. Hereinafter, the minimum configurations necessary for basic operations of the first light-emitting element 11, the second light-emitting element 12, and the third light-emitting element 13 will be described for convenience of description.

The light-emitting device 100 according to one or more embodiments may include a first insulating layer 21 disposed on a lower surface of the light-emitting structure 10. The first insulating layer 21 may include silicon oxide (SiO₂). In the light-emitting structure 10, the first insulating layer 21, the first light-emitting element 11, the second light-emitting element 12, and the third light-emitting element 13 are sequentially arranged in the vertical direction, and the lower surface of the first insulating layer 21 may be a lower surface of the light-emitting structure 10, and an upper surface of the third light-emitting element 13 may be an upper surface of the light-emitting structure 10.

The light-emitting device 100 according to one or more embodiments may further include one or more holes penetrating a partial area of the light-emitting structure 10. For example, a first hole H1 penetrating the first insulating layer 21 from a lower surface of the light-emitting structure 10 to expose the p-type semiconductor layer P1 of the first light-emitting element 11, a second hole H2 penetrating the first light-emitting element 11 from the lower surface of the light-emitting structure 10 to expose the first insulating layer 21 and the p-type semiconductor layer P2 of the second light-emitting element 12, a third hole H3 penetrating the first insulating layer 21, the first light-emitting element 11, and the second light-emitting element 12 from the lower surface of the light-emitting structure 10 to expose the p-type semiconductor layer P3 of the third light-emitting element 13, a fourth hole H4 penetrating the third light-emitting element 13 and the second light-emitting element 12 from an upper surface of the light-emitting structure 10 (an upper surface of the third light-emitting element 13) to expose the n-type semiconductor layer N1 of the first light-emitting element 11, and a fifth hole H5 penetrating the third light-emitting element 13 from the upper surface of the light-emitting structure 10 to expose the n-type semiconductor layer N2 of the second light-emitting element 12 may be disposed in the light-emitting structure 10. The first to fifth holes H1, H2, H3, H4, and H5 may be spatially spaced apart from each other.

Because the second to fifth holes H2, H3, H4, and H5 partially penetrate the active layers A1, A2, and A3 of the light-emitting structure 10, the areas of the active layers A1, A2, and A3 may be reduced. The active layer A1 of the first light-emitting element 11 may be penetrated by the second hole H2 and the third hole H3, the active layer A2 of the second light-emitting element 12 may be penetrated by the third hole H3 and the fourth hole H4, and the active layer A3 of the third light-emitting element 13 may be penetrated by the fourth hole H4 and the fifth hole H5. Because the areas of the active layers A1, A2, and A3 of the light-emitting structure 10 according to one or more embodiments are almost uniformly removed by the second to fifth holes H2, H3, H4, and H5, a significant portion of a specific active layer being removed may be prevented.

In addition, because the active area of the light-emitting structure 10 is reduced by the widths of the second to fifth holes H2, H3, H4, and H5, the widths of the second to fifth holes H2, H3, H4, and H5 may be relatively small in the horizontal direction (X direction and/or Y direction). The width of each of the second to fifth holes H2, H3, H4, and H5 may be equal to or less than 1/5 of the width of the light-emitting structure 10. For example, the width of each of the second to fifth holes H2, H3, H4, and H5 may be less than or equal to about 1 *µ*m and less than or equal to about 0.5 *µ*m in the horizontal direction (X direction and/or Y direction).

The first hole H1 may be spaced apart from the second hole H2 and the third hole H3. The light-emitting device 100 according to one or more embodiments may further include a second insulating layer 22 provided on and surrounding side surfaces of holes formed inside the light-emitting structure 10, that is, the second to fifth holes H2, H3, H4, and H5. The second insulating layer 22 may include a transparent insulating material. For example, the second insulating layer 22 may include SiO₂, silicon nitride (SiN), aluminum oxide (Al₂O₃), etc.

The light-emitting device 100 according to one or more embodiments may further include a first electrode pattern 30 exposed on the lower surface of the light-emitting structure 10 (i.e., the lower surface of the first insulating layer 21) while being electrically and/or physically connected to the p-type semiconductor layers P1, P2, and P3 of the light-emitting structure 10 and a second electrode pattern 40 exposed on the upper surface of the light-emitting structure 10 (i.e., the upper surface of the third light-emitting element 13 or the upper surface of the n-type semiconductor layer N3 of the third light-emitting element 13) while being electrically and/or physically connected to the n-type semiconductor layers N1, N2, and N3 of the light-emitting structure 10. For example, the first electrode pattern 30 may protrude from a surface of the p-type semiconductor layer P1 of the first light-emitting element 11 while being electrically and/or physically connected to the p-type semiconductor layers P1, P2, and P3 of the light-emitting structure 10 by using one or more holes. The second electrode pattern 40 may protrude from a surface of the n-type semiconductor layer N3 of the third light-emitting element 13 while being electrically and/or physically connected to the n-type semiconductor layers N1, N2, and N3 of the light-emitting structure 10 by using one or more holes.

The first light-emitting element 11, the second light-emitting element 12, and the third light-emitting element 13 may receive a common voltage through one of the first electrode pattern 30 and the second electrode pattern 40, and each may receive an independent driving voltage through the other one of the first electrode pattern 30 and the second electrode pattern 40. As the first electrode pattern 30 is exposed on the lower surface of the light-emitting structure 10, and the second electrode pattern 40 is exposed on the upper surface of the light-emitting structure 10, because the first electrode pattern 30 and the second electrode pattern 40 are formed on different surfaces of the light-emitting structure 10, a combination of a module providing a voltage and electrode patterns may be easily performed.

The first electrode pattern 30 may include a first electrode 31 electrically and/or physically connected to the p-type semiconductor layer P1 of the first light-emitting element 11, a second electrode 32 electrically and/or physically connected to the p-type semiconductor layer P2 of the second light-emitting element 12, and a third electrode 33 electrically and/or physically connected to the p-type semiconductor layer P3 of the third light-emitting element 13. The first to third electrodes 31, 32, and 33 may respectively include conductive vias 31a, 32a, and 33a respectively filling the first to third holes H1, H2, and H3, and conductive pads 31b, 32b, and 33b extending onto the surface of the first insulating layer 21 while being in contact with the corresponding conductive vias 31a, 32a, and 33a. The conductive pads 31b, 32b, and 33b may be spaced apart from each other.

The second electrode pattern 40 may include a fourth electrode 41 electrically and/or physically connected to the n-type semiconductor layer N1 of the first light-emitting element 11, a fifth electrode 42 electrically and/or physically connected to the n-type semiconductor layer N2 of the second light-emitting element 12, and a sixth electrode 43 electrically and/or physically connected to the n-type semiconductor layer N3 of the third light-emitting element 13. The fourth electrode 41 and the fifth electrode 42 may have conductive via shapes respectively filling the fourth hole H4 and the fifth hole H5, and the sixth electrode 43 may have a conductive pad shape disposed on the n-type semiconductor layer N3 of the third light-emitting element 13.

The first electrode 31 may be in contact with the p-type semiconductor layer P1 of the first light-emitting element 11, and the fourth electrode 41 may penetrate the third light-emitting element 13 and the second light-emitting element 12 to be in contact with the n-type semiconductor layer N1 of the first light-emitting element 11. In other words, the first electrode 31 may be in contact with the surface of the p-type semiconductor layer P1 of the first light-emitting element 11 while filling the first hole H1 included in the first insulating layer 21, and may extend onto the first insulating layer 21. The fourth electrode 41 may be in contact with the n-type semiconductor layer N1 of the first light-emitting element 11 while being filling the fourth hole H4 penetrating the third light-emitting element 13 and the second light-emitting element 12. The first light-emitting element 11 may emit red light in response to an electrical signal applied through the first electrode 31 and the fourth electrode 41.

The second electrode 32 may penetrate the first light-emitting element 11 to be in contact with the p-type semiconductor layer P2 of the second light-emitting element 12, and the fifth electrode 42 may penetrate the third light-emitting element 13 to be in contact with the n-type semiconductor layer N2 of the second light-emitting element 12. For example, the second electrode 32 may be in contact with the p-type semiconductor layer P2 of the second light-emitting element 12 while filling the second hole H2 penetrating the first light-emitting element 11, and the fifth electrode 42 may be in contact with the n-type semiconductor layer N2 of the second light-emitting element 12 while filling the fifth hole H5 penetrating the third light-emitting element 13. The second light-emitting element 12 may emit green light in response to an electrical signal applied through the second electrode 32 and the fifth electrode 42. For example, the second light may have a wavelength shorter than a wavelength of the first light.

The third electrode 33 may penetrate the first light-emitting element 11 and the second light-emitting element 12 to be in contact with the p-type semiconductor layer P3 of the third light-emitting element 13, and the sixth electrode 43 may be in contact with the n-type semiconductor layer N3 of the third light-emitting element 13. For example, the third electrode 33 may be in contact with the p-type semiconductor layer P3 of the third light-emitting element 13 while filling the third hole H3 penetrating the first light-emitting element 11 and the second light-emitting element 12, and the sixth electrode 43 may be in contact with the n-type semiconductor layer N3 of the third light-emitting element 13. The third light-emitting element 13 may emit blue light in response to an electrical signal applied through the third electrode 33 and the sixth electrode 43.

When the first electrode pattern 30 applies an independent driving voltage to each of the first light-emitting element 11, the second light-emitting element 12, and the third light-emitting element 13, the first electrode 31, the second electrode 32, and the third electrode 33 may not be connected to each other. When the second electrode pattern 40 applies a common voltage to the first light-emitting element 11, the second light-emitting element 12, and the third light-emitting element 13, the fourth electrode 41, the fifth electrode 42 and the sixth electrode 43 may be disposed to be connected to each other. For example, the sixth electrode 43 may be disposed on the upper surface of the light-emitting structure 10, that is, on the upper surface of the n-type semiconductor layer N3 of the third light-emitting element 13 while being in contact with the fourth electrode 41 and the fifth electrode 42. However, embodiments are not limited thereto. Even when the second electrode pattern 40 applies the common voltage to the first light-emitting element 11, the second light-emitting element 12, and the third light-emitting element 13, at least one of the fourth electrode 41, the fifth electrode 42 and the sixth electrode 43 may not be connected to each other.

The conductive vias 31a, 32a, and 33a included in the first electrode pattern 30 and the second conductive pattern 40 may include transparent conductive materials. For example, at least one of conductive vias 31a, 32a, and 33a included in the first electrode pattern 30 and the second conductive pattern 40 may include a conductive oxide such as an indium tin oxide (ITO), an indium zinc oxide (IZO), zinc oxide (ZnO), and indium tin zinc oxide (ITZO), a conductive polymer such as PEDOT (poly(3,4-ethylenedioxythiophene)), etc. As another example, the conductive pads 31b, 32b, and 33b included in the first electrode pattern 30 may include a transparent conductive material or a non-transparent or reflective conductive material. When the conductive pads 31b, 32b, and 33b included in the first electrode pattern 30 include a reflective conductive material, the conductive pads 31b, 32b, and 33b may perform reflective functions. The conductive pads 31b, 32b, and 33b included in the first electrode pattern 30 may include metal materials, for example, silver (Ag), gold (Au), platinum (Pt), nickel (Ni), chromium (Cr), and/or aluminum (Al), but are not limited thereto.

It has been described above that the first light-emitting element 11 emits red light, the second light-emitting element 12 emits green light, and the third light-emitting element 13 emits blue light, but the disclosure is not limited thereto. That is, it has been described above that the first light-emitting element 11 emits light of a wavelength longer than that of the second light-emitting element 12, and the third light-emitting element 13 emits light of a wavelength shorter than that of the second light-emitting element 12. However, the disclosure is not limited thereto. The first light-emitting element 11 may emit light of a wavelength shorter than that of the second light-emitting element 12, or the third light-emitting element 13 may emit light of a wavelength longer than that of the second light-emitting element 12, and the wavelength of light emitted by each of the first light-emitting element 11, the second light-emitting element 12, and the third light-emitting element 13 may be determined according to an application example.

It has been described above that the light-emitting device 100 according to one or more embodiments includes three light-emitting elements that emit light of different wavelengths, but the disclosure is not limited thereto. The light-emitting element 100 may include two light-emitting elements that emit light of different wavelengths, and may include four or more light-emitting elements. Alternatively, the light-emitting device 100 may emit light in a visible light band, but may also emit light in an invisible light band.

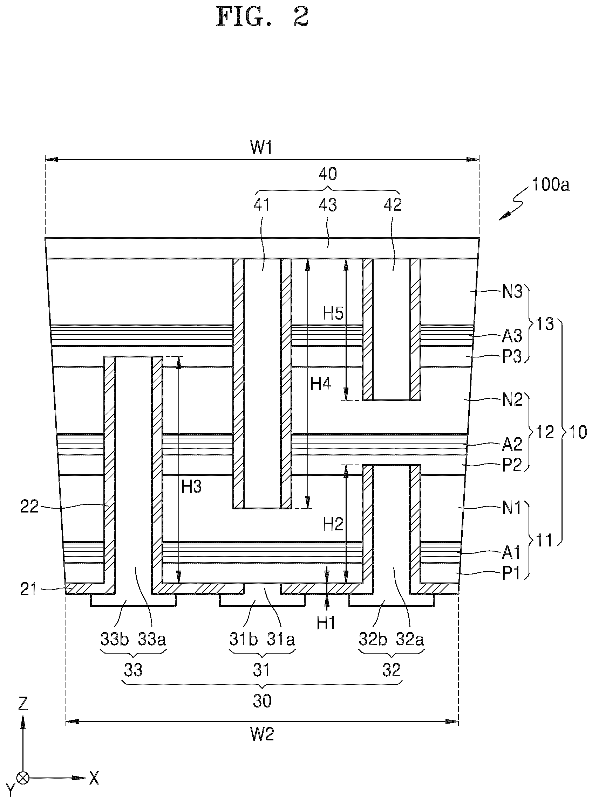

FIG. 2 is a diagram illustrating a light-emitting device 100a including the first light-emitting element 11, the second light-emitting element 12, and the third light-emitting element 13 having varying widths according to one or more embodiments. Referring to FIGS. 1 and 2, a lower surface and an upper surface of the light-emitting structure 10 of FIG. 2 may have different sizes. For example, a width W1 of the upper surface of the light-emitting structure 10 may be greater than a width W2 of the lower surface of the light-emitting structure 10. A width W of the light-emitting structure 10 in the horizontal direction (X-direction and/or Y direction) may gradually increase from the lower surface to the upper surface of the light-emitting structure 10. As will be described below, the light-emitting structure 10 may grow and be formed in the order of the third light-emitting element 13, the second light-emitting element 12, and the first light-emitting element 11. As the third light-emitting element 13, the second light-emitting element 12, and the first light-emitting element 11 grow and are formed, widths of the third light-emitting element 13, the second light-emitting element 12, and the first light-emitting element 11 may gradually decrease in the horizontal direction (X direction and/or Y direction).

Even though the width of the active layer A3 of the third light-emitting element 13 is greater than the width of the active layer A1 of the first light-emitting element 11 in the horizontal direction (X direction and/or Y direction), each of the third light-emitting element 13, the second light-emitting element 12, and the first light-emitting element 11 may need to secure an almost uniform active area. The width of the active layer A3 of the third light-emitting element 13 may be about 0.9 times or more and about 1.1 times or less than the width of the active layer A1 of the first light-emitting element 11 in the horizontal direction (X direction and/or Y direction).

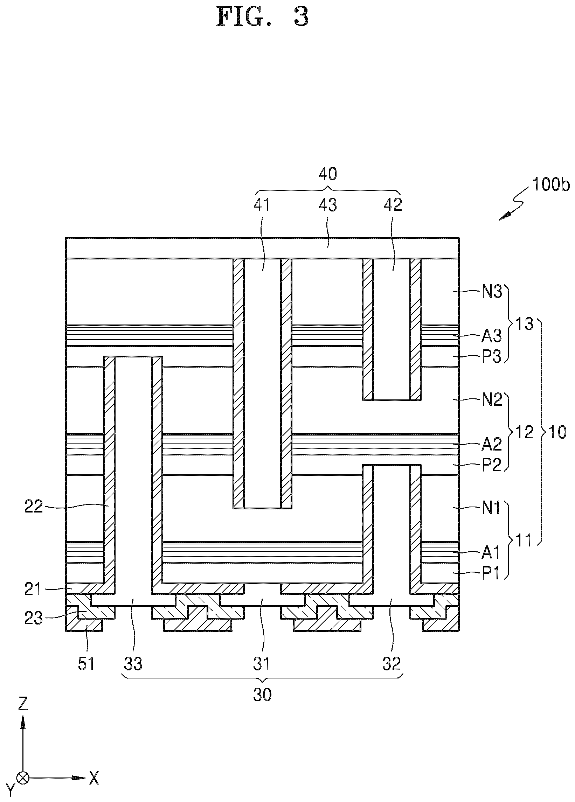

FIG. 3 is a diagram illustrating a light-emitting device 100b including a first reflective layer 51 according to one or more embodiments. Upon comparing FIG. 1 with FIG. 3, the light-emitting device 100b of FIG. 3 may further include a third insulating layer 23 disposed on the first insulating layer 21 and the first electrode pattern 30, and the first reflective layer 51 disposed on the third insulating layer 23 in a lower surface of the light-emitting structure 10. The third insulating layer 23 and the first reflective layer 51 may include holes overlapping the first hole H1, the second hole H2, and the third hole H3 in the vertical direction (Z direction) of the light-emitting structure 10. Thus, the first electrode 31, the second electrode 32, and the fifth electrode 33 of the first electrode pattern 30 may be exposed to the outside by the holes of the third insulating layer 23 and the first reflective layer 51. Similar to the first insulating layer 21, the third insulating layer 23 may include a transparent insulating material.

The first reflective layer 51 may reflect incident light into the light-emitting structure 10. The first reflective layer 51 may reflect the incident light into the light-emitting structure 10 and emit the incident light to the outside through an upper surface of the light-emitting structure 10, thereby increasing the light emission efficiency emitted to the upper surface of the light-emitting structure 10. The first reflective layer 51 may include a material of high reflectivity with respect to light. The first reflective layer 51 may include a metal material, for example, Ag, Au, Pt, Ni, Cr, and/or A1, but is not limited thereto. When the conductive pads 31b, 32b, and 33b of the first electrode pattern 30 includes metals of relatively high reflectivity, light emitted to the lower surface of the light-emitting structure 10 may be more effectively reduced. When the conductive pads 31b, 32b, and 33b of the first electrode pattern 30 partially overlap the first reflective layer 51 in the vertical direction (Z direction) of the light-emitting structure 10, reflection efficiency on the lower surface of the light-emitting structure 10 may be further increased.

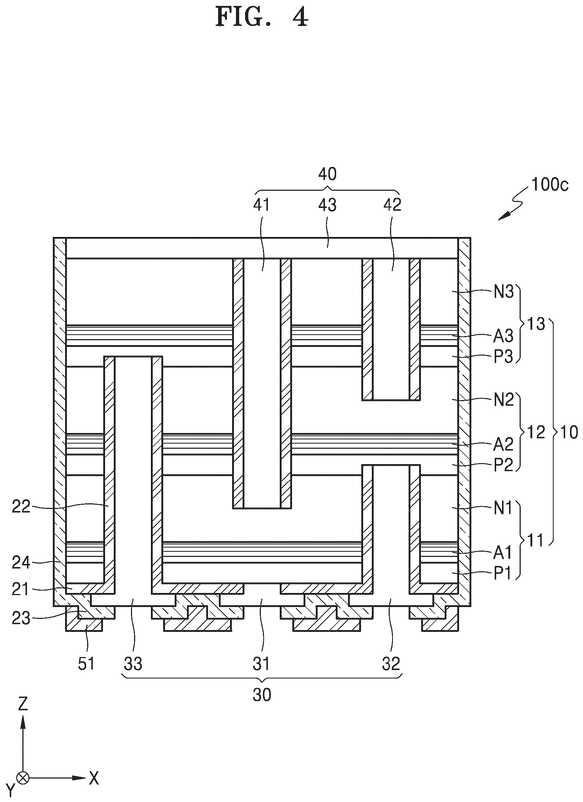

FIG. 4 is a diagram illustrating a light-emitting device 100c including a fourth insulating layer 24 according to one or more embodiments. Upon comparing FIG. 3 with FIG. 4, the light-emitting device 100c of FIG. 4 may further include the fourth insulating layer 24 provided on and surrounding a side surface of the light-emitting structure 10. The fourth insulating layer 24 may be a protective layer protecting the light-emitting structure 10 from the outside. Similar to the first insulating layer 21, the fourth insulating layer 24 may include a transparent insulating material. However, embodiments are not limited thereto. The fourth insulating layer 24 may be a black matrix material. Thus, the fourth insulating layer 24 may prevent light generated by the light-emitting structure 10 from being emitted to the side surface of the light-emitting structure 10 or prevent light from being incident on the side surface of the light-emitting structure 10 from the outside.

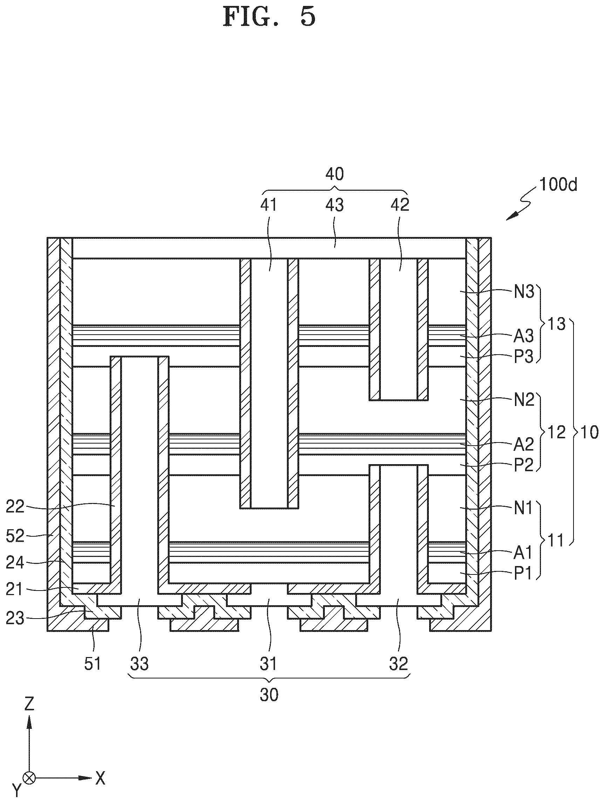

FIG. 5 is a diagram illustrating a light-emitting device 100d including a second reflective layer 52 according to one or more embodiments. The light-emitting device 100d of FIG. 5 may further include the second reflective layer 52 provided on and surrounding a side surface of the light-emitting structure 10. The second reflective layer 52 may be disposed on the fourth insulating layer 24. The second reflective layer 52 may reflect light traveling to the side surface of the light-emitting structure 10 into the inside of the light-emitting structure 10. Thus, the light generated by the light-emitting structure 10 may be emitted to the outside through an upper surface of the light-emitting structure 10, thereby increasing the light emission efficiency in a direction of the upper surface of the light-emitting structure 10.

The light-emitting devices 100, 100a, 100b, 100c, and 100d according to one or more embodiments may emit light of a plurality of different wavelengths and accordingly be used as pixels of a display apparatus. The one light-emitting device 100, 100a, 100b, 100c, or 100d becomes one pixel, and thus a relatively small and high-resolution display apparatus may be implemented.

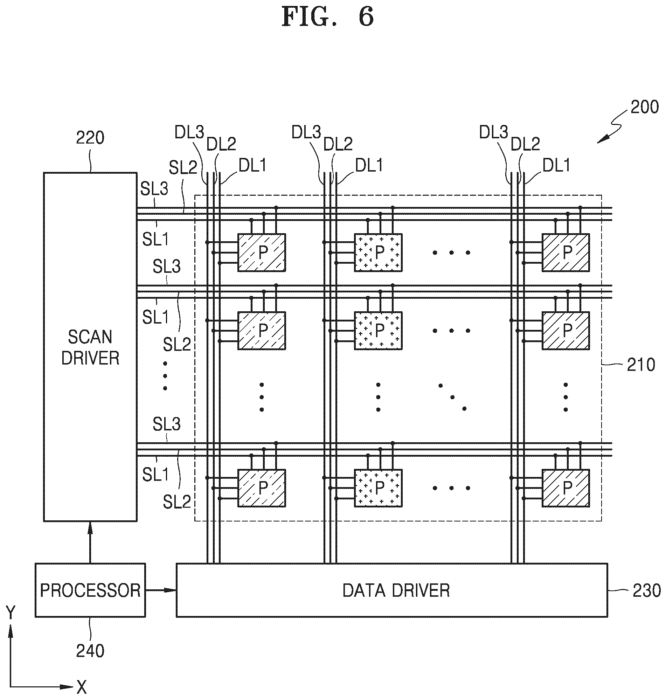

FIG. 6 is a block diagram of a display apparatus 200 including a light-emitting device according to one or more embodiments. Referring to FIG. 6, the display apparatus 200 may include a pixel array 210, a scan driver 220, a data driver 230, and a processor 240. The pixel array 210 may include a plurality of pixels P arranged in a two-dimensional (2D) array form, a plurality of scan line sets transmitting scan signals to the plurality of pixels P, and a plurality of data line sets transmitting data signals to the plurality of pixels P.

At least one of the plurality of pixels P of the pixel array 210 may include the light-emitting device 100, 100a, 100b, 100c, or 100d described above. For example, at least one of the plurality of pixels P may include the one light-emitting device 100, 100a, 100b, 100c, or 100d, including the first light-emitting element 11 emitting red light, the second light-emitting element 12 emitting green light, and the third light-emitting element 13 emitting blue light, and a first transistor TR1, a second transistor TR2, and a third transistor TR3 electrically and/or physically connected to the first light-emitting element 11, the second light-emitting element 12, and the third light-emitting element 13, respectively.

Each of scan line sets may include a first scan line SL1, a second scan line SL2, and a third scan line SL3 extending in an X direction. The first scan line SL1, the second scan line SL2, and the third scan line SL3 may be respectively connected to the plurality of pixels P arranged in the X direction. For example, the first scan line SL1 may be electrically and/or physically connected to a gate electrode G of the first transistor TR1 in each of the pixels P, the second scan line SL2 may be electrically and/or physically connected to the gate electrode G of the second transistor TR2 in each of the pixels P, and the third scan line SL3 may be electrically and/or physically connected to the gate electrode G of the third transistor TR3 in each of the pixels P. The first scan line SL1, the second scan line SL2, and the third scan line SL3 may also be connected to the scan driver 220 to receive scan signals from the scan driver 220.

Each of data line sets may include a first data line DL1, a second data line DL2, and a third data line DL3 extending in a Y direction. The first data line DL1, the second data line DL2, and the third data line DL3 may be respectively connected to the plurality of pixels P arranged in the Y direction. For example, the first data line DL1 may be electrically connected to a source horizontal line SHL of the first transistor TR1 in each of the pixels P, the second data line DL2 may be electrically connected to the source horizontal line SHL of the second transistor TR2 in each of the pixels P, and the third data line DL3 may be electrically connected to the source horizontal line SHL of the third transistor TR3 in each of the pixels P. The first data line DL1, the second data line DL2, and the third data line DL3 may also be connected to the data driver 230 to receive data signals from the data driver 230.

The processor 240 may control operations of the scan driver 220 and the data driver 230 based on data of images to be displayed by the pixel array 210, thereby adjusting the scan signal and the data signal provided to each of the pixels P.

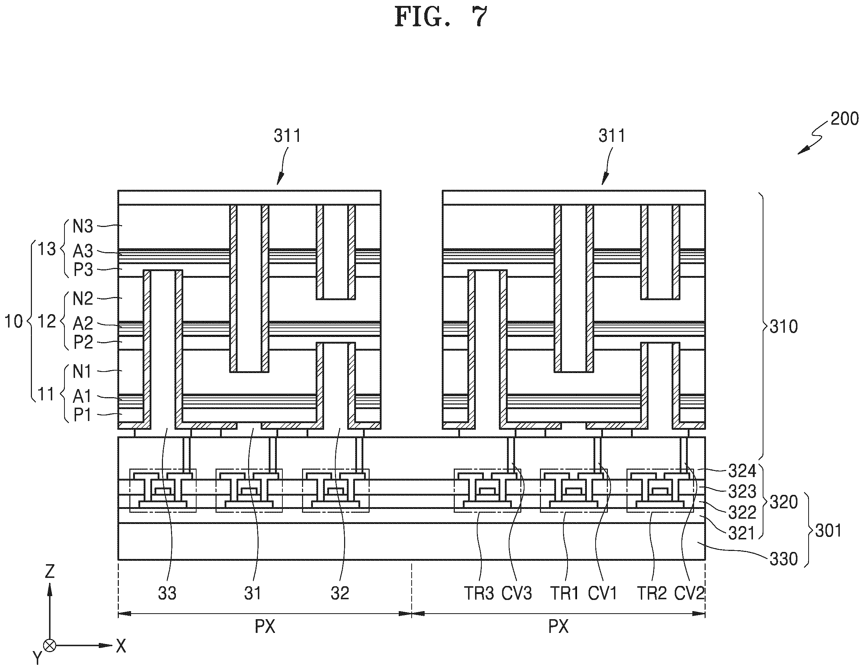

FIG. 7 is a diagram illustrating a portion of the display apparatus 200 including a plurality of light-emitting devices 311 according to one or more embodiments. Referring to FIG. 7, the display apparatus 200 may include a display layer 310 including the plurality of light-emitting devices 311, a driving layer 320 driving the plurality of light-emitting devices 311, and a substrate 330 supporting the driving layer 320. The driving layer 320 and the substrate 330 are collectively referred to as a backplane 301.

The display layer 310 may include the plurality of light-emitting devices 311. At least one of the plurality of light-emitting devices 311 may include the first light-emitting element 11, the second light-emitting element 12, and the third light-emitting element 13 which emit light of different wavelengths. From the perspective of the display apparatus 200, the first light-emitting element 11 may be a component of a first sub-pixel, the second light-emitting element 12 may be a component of a second sub-pixel, and the third light-emitting element 13 may be a component of a third sub-pixel. The light-emitting element 311 has been described above, and thus a detailed description thereof will be omitted. The light-emitting device 100 shown in FIG. 1 is shown in FIG. 7, but embodiments are not limited thereto. The display apparatus 200 may include the light-emitting device 100a, 100b, 100c, or 100d shown in FIG. 2, 3, 4, or 5.

The substrate 330 may include an insulating material such as, for example, glass, an organic polymer, crystal, etc. In addition, the substrate 330 may include a material of flexibility to be bent or folded, and may have a single-layer structure or a multi-layer structure.

The driving layer 320 may include a buffer layer 321 disposed on the substrate 330 and a transistor TFT disposed on the buffer layer 321. The driving layer 320 may further include a driving voltage wiring, the scan driver 220, the data driver 230, and the processor 240, which are not shown in FIG. 7.

The buffer layer 321 may prevent diffusion of impurities into the transistor TFT. The buffer layer 321 may be provided as a single layer, but may be provided as at least a double layer or multiple layers.

When the buffer layer 321 is provided as multiple layers, the multiple layers may include the same material or may include different materials. The buffer layer 321 may be omitted according to a material and process conditions of the substrate 330.

The first to third transistors TR1, TR2, and TR3 may drive corresponding light-emitting elements included in the display layer 310. For example, the driving layer 320 may include the first transistor TR1 driving the first light-emitting element 11, the second transistor TR2 driving the second light-emitting element 12, and the third transistor TR3 driving the third light-emitting element 13. Each of the first to third transistors TR1, TR2, and TR3 may include a semiconductor layer SC, a gate electrode G, a source electrode S, and a drain electrode D.

The semiconductor layer SC may be disposed on the buffer layer 321. The semiconductor layer SC may include a source area in contact with the source electrode S and a drain area in contact with the drain electrode D. An area between the source area and the drain area may be a channel area.

The semiconductor layer SC may be a semiconductor pattern including polysilicon, amorphous silicon, oxide semiconductor, etc. The channel area is a semiconductor pattern that is not doped with impurities, and may be an intrinsic semiconductor. The source area and the drain area may be semiconductor patterns doped with impurities.

The gate electrode G may be provided on the semiconductor layer SC with the gate insulating layer 322 disposed the gate electrode G and the semiconductor layer SC.

Each of the source electrode S and the drain electrode D may be in contact with the source area and the drain area of the semiconductor layer SC through a contact hole penetrating an interlayer insulating layer 323 and a gate insulating layer 322.

A protection layer 324 may be provided on the first to third transistors TR1, TR2, and TR3. The protective layer 324 may include first to third conductive vias CV1, CV2, and CV3. The first electrode 31 may be electrically connected to the first transistor TR1 (e.g., drain of the first transistor TR1) through the first conductive via CV1, the second electrode 32 may be electrically connected to the second transistor TR2 (e.g., drain of the second transistor TR2) through the second conductive via CV2, and the third electrode 33 may be electrically connected to the third transistor TR3 (e.g., drain of the third transistor TR3) through the third conductive via CV3. Although not shown in FIG. 7, the second electrode pattern 40 may also be connected to a circuit module of the driving layer 320 through a wiring.

When a driving voltage is applied through the first electrode pattern 30 and a common voltage is applied through the second electrode pattern 40, each of the first light-emitting element 11, the second light-emitting element 12, and the third light-emitting element 13 may independently emit light based on the applied voltage.

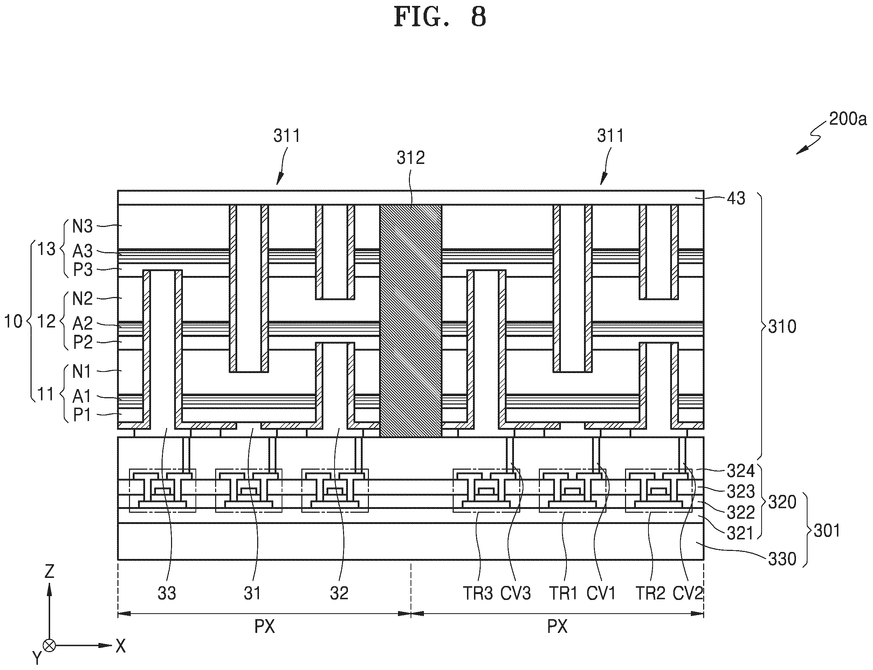

FIG. 8 is a diagram illustrating a display apparatus 200a including a pixel partition 312 according to one or more embodiments.

Referring to FIGS. 7 and 8, the display apparatus 200a of FIG. 8 may further include the pixel partition 312 disposed between the light-emitting devices 311. The pixel partition 312 may improve contrast by preventing mixing between lights emitted from the light-emitting devices 311. The pixel partition 312 may include at least one of, for example, a black matrix material, a resin, or a polymer.

The sixth electrodes 43 included in the neighboring and adjacent light-emitting devices 311 may extend to an upper surface of the pixel partition 312 to be connected to each other. For example, the sixth electrodes 43 included in the neighboring and adjacent light-emitting devices 311 may be disposed on the same plane. The sixth electrodes 43 included in the plurality of light-emitting devices 311 are connected to each other, and thus the number of circuit modules applying a common voltage may be reduced.

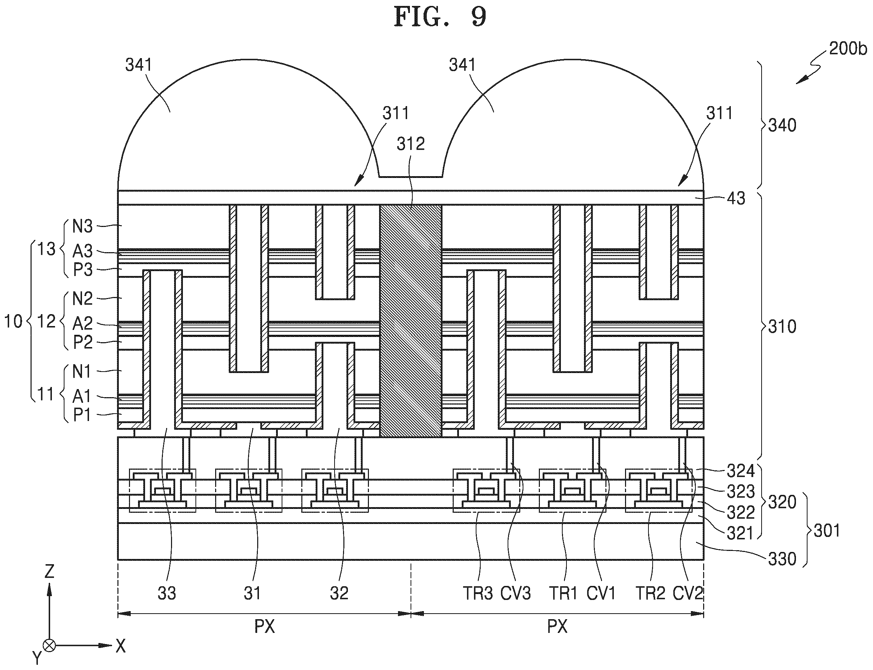

FIG. 9 is a diagram illustrating a display apparatus 200b including an optical layer 340 controlling an optical path according to one or more embodiments.

Referring to FIGS. 8 and 9, the display apparatus 200b of FIG. 9 may include the optical layer 340 disposed on the display layer 310 and may control a traveling path of light emitted from the display layer 310. The optical layer 340 may include a plurality of microlenses 341 disposed to correspond to the plurality of light-emitting devices 311 on a one-to-one basis. Each of the microlenses 341 may guide along a specific direction by adjusting a traveling path of light emitted to the corresponding light-emitting element 311. The microlenses 341 may have different refractive indexes and thus focus light emitted from the display layer 310. Accordingly, the display apparatus 200b may generate an image of a relatively small viewing angle. The optical layer 340 may enlarge or reduce an image generated in the display layer 310 according to the use of the display apparatus 200b. In addition, the optical layer 340 may prevent mixing of lights emitted from the adjacent light-emitting element 311.

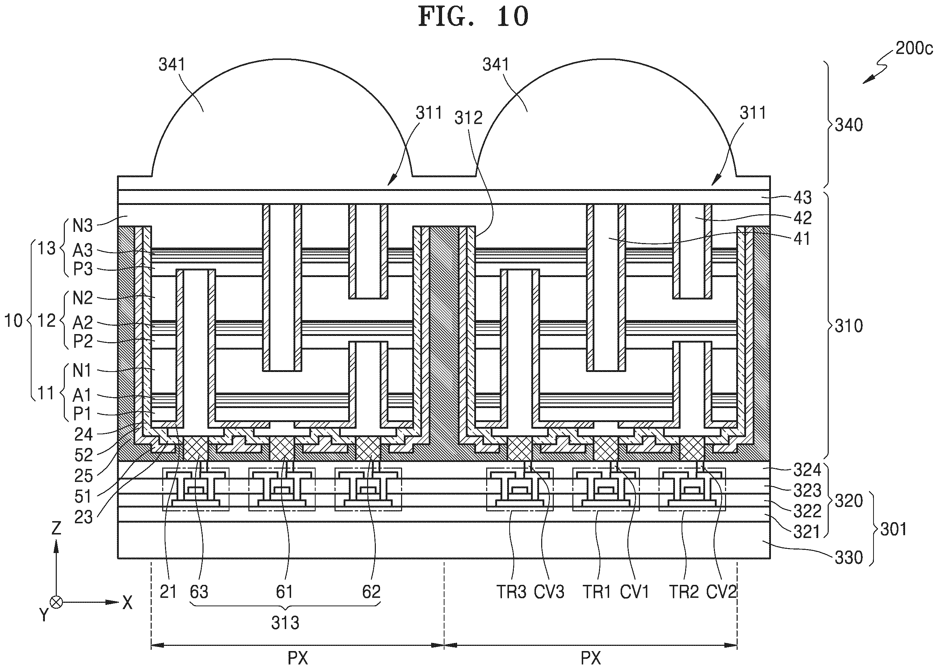

FIG. 10 is a diagram illustrating a display apparatus 200c to which the light-emitting devices 311 are connected according to one or more embodiments.

Referring to FIGS. 9 and 10, the n-type semiconductor layers N3 of the third light-emitting elements 13 may be connected to each other in the neighboring and adjacent light-emitting devices 311 of the display apparatus 200c of FIG. 10. The pixels PX may be partitioned by the pixel partition 312 penetrating a partial area of the light-emitting structure 10. The pixel partition 312 may be a trench penetrating the p-type semiconductor layers P3 of the first light-emitting element 11, the second light-emitting element 12, and the third light-emitting element 13, and the active layer A3 of the third light-emitting element 13. The trench may form a closed loop, and the shape of the closed loop may be a cross-sectional shape of the pixel PX. For example, from the perspective of the vertical direction (Z direction) of the display layer 310, the cross-sectional shape of the pixel partition 312 may be a polygon, for example, a square. When the cross-sectional shape of the pixel partition 312 is a polygon, the display apparatus 200c of a higher resolution per unit area may be implemented compared to a circular or elliptical cross-sectional shape. A width of the pixel partition 312 may be determined by a distance between the pixels PX. The fourth insulating layer 24 and the second reflective layer 52 may be sequentially disposed on a side surface of the pixel partition 312.

The display layer 320 may further include a contact electrode pattern 313 electrically connecting the first electrode 31, the second electrode 32, and the fifth electrode 33 to the driving layer 320. The contact electrode pattern 313 may include a first contact electrode 61 electrically connecting the first electrode 31 to the driving layer 320, a second contact electrode 62 electrically connecting the second electrode 32 to the driving layer 320, and a third contact electrode 63 electrically connecting the fifth electrode 33 to the driving layer 320. The contact electrode pattern 313 may include a conductive material. For example, the contact electrode pattern 313 may be a bonding metal such as gold (Au), tin (Sn), or copper (Cu).

The display layer 310 may further include a fifth insulating layer 25 filling the remaining space of the pixel partition 312 and a space between the display layer 310 and the driving layer 320. The fifth insulating layer 25 may include at least one of a black matrix material, a resin, or a polymer. As another example, the fifth insulating layer 25 may include a transparent inorganic material such as SiO₂.

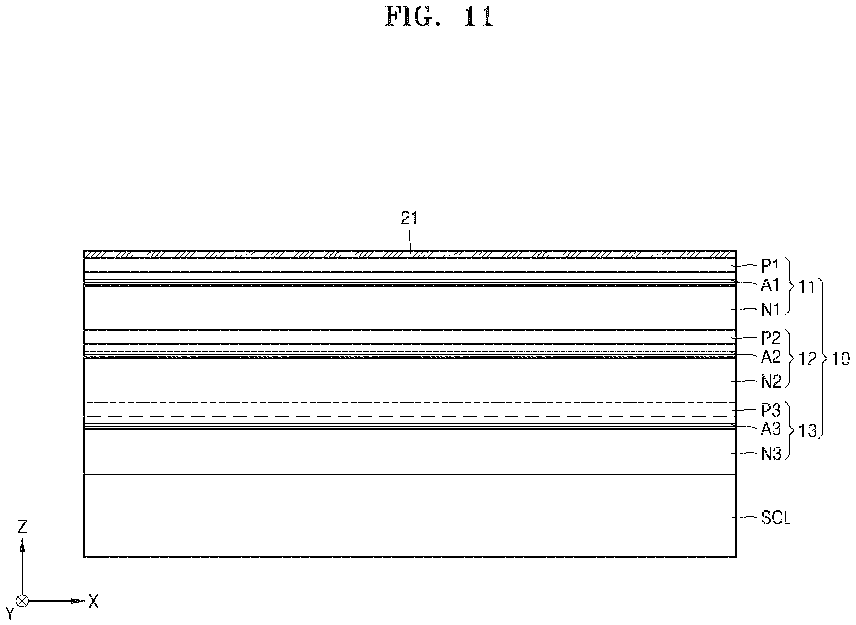

FIGS. 11 to 21 are reference diagrams for describing a method of manufacturing the display apparatus 200c according to one or more embodiments.

Referring to FIG. 11, the light-emitting structure 10 may be formed in the sacrificial layer SCL. The sacrificial layer SCL may be a layer for growing a light-emitting device. The sacrificial layer SCL may include various materials used in a general semiconductor process. For example, a silicon substrate SUB or a sapphire substrate SUB may be used as the sacrificial layer SCL.

The third light-emitting element 13, the second light-emitting element 12, and the first light-emitting element 11 may be sequentially and vertically formed on the sacrificial layer SCL. For example, the n-type semiconductor layer N3, the active layer A3, and the p-type semiconductor layer P3 of the third light-emitting element 13 may be sequentially grown on the sacrificial layer SCL, the n-type semiconductor layer N2, the active layer A2, and the p-type semiconductor layer P2 of the second light-emitting element 12 may be sequentially grown on the p-type semiconductor layer P3 of the third light-emitting element 13, and the n-type semiconductor layer N1, the active layer A1, and the p-type semiconductor layer P1 of the first light-emitting element 11 may be sequentially grown on the p-type semiconductor layer P2 of the second light-emitting element 12.

Among the first light-emitting element 11, the second light-emitting element 12, and the third light-emitting element 13, the lowest indium content may be included in the active layer A3 of the third light-emitting element 13, and the highest indium content may be included in the active layer A1 of the first light-emitting element 11. In general, the lower the indium content, the higher the growth temperature of the nitride semiconductor, and thus an active layer with a relatively high growth temperature may be grown first and an active layer with a relatively low growth temperature may be grown later. When an active layer having a lower indium content is first grown and an active layer having a higher indium content is subsequently grown, the active layer having the higher indium content may deteriorate. The growth order of the light-emitting structure 10 according to one or more embodiments may prevent deterioration of the active layer A1 of the first light-emitting element 11 having the highest indium content.

The light-emitting structure 10 according to one or more embodiments may not include a bonding material between the first light-emitting element 11, the second light-emitting element 12, and the third light-emitting element 13 because the third light-emitting element 13, the second light-emitting element 12, and the first light-emitting element 11 are sequentially and monolithically formed.

The light-emitting structure 10 may be formed using a method such as, for example, metal organic chemical vapor deposition (MOCVD), chemical vapor deposition (CVD), plasma-enhanced chemical vapor deposition (PECVD), molecular beam epitaxy (MBE), hydride vapor phase epitaxy (HVPE), etc.

The first insulating layer 21 may be further formed on the light-emitting structure 10, that is, the p-type semiconductor layer P1 of the first light-emitting element 11. The first insulating layer 21 may be formed through a CVD process.

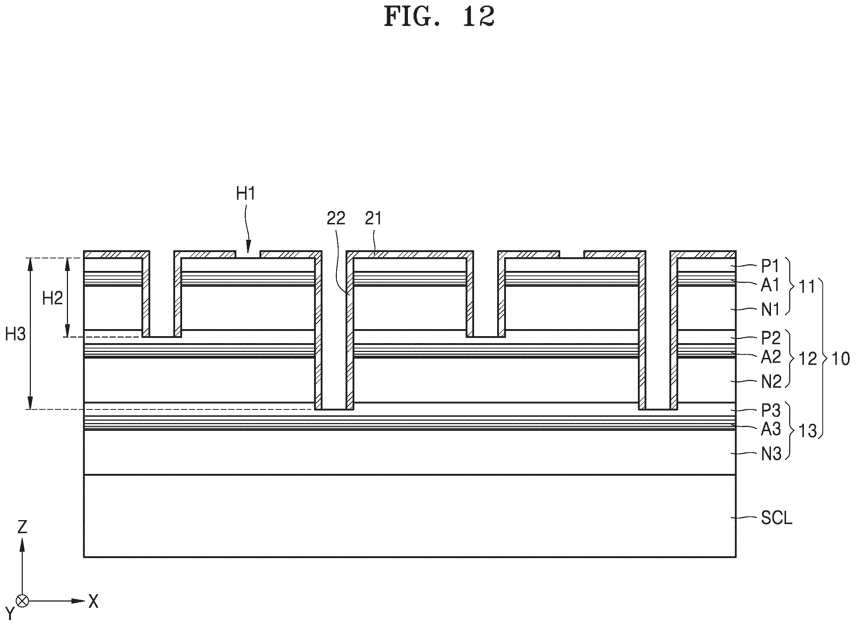

Referring to FIG. 12, the first hole H1 exposing the p-type semiconductor layer P1 of the first light-emitting element 11, the second hole H2 exposing the p-type semiconductor layer P2 of the second light-emitting element 12, and the third hole H3 exposing the p-type semiconductor layer P3 of the third light-emitting element 13 may be formed in the light-emitting structure 10, and the second insulating layer 22 provided on and surrounding side surfaces of the second hole H2 and the third hole H3 may be formed. The second hole H2 may penetrate the first light-emitting element 11, and the third hole H3 may penetrate the first light-emitting element 11 and the second light-emitting element 12. Thus, the active areas of the first light-emitting element 11, the second light-emitting element 12, and the third light-emitting element 13 may be reduced. Therefore, the widths of the second hole H2 and the third hole H3 may be small such as less than or equal to about 1 *µ*m or less than or equal to about 0.5 *µ*m in the horizontal direction (X direction and/or Y direction). The second hole H2 and the third hole H3 may be performed through, for example, a plasma etching process. Because the first hole H1 is formed by etching only the first insulating layer 21, an etching process other than the plasma etching process may be applied. For example, the first hole H1 may be formed through dry etching or wet etching.

The second insulating layer 22 may be formed through, for example, an atomic layer deposition process. Even though the first insulating layer 21 is provided on and surrounds the side surfaces of the second hole H2 and the third hole H3, the p-type semiconductor layer P2 of the second light-emitting element 12 and the p-type semiconductor layer P3 of the third light-emitting element 13 may still be exposed to the outside.

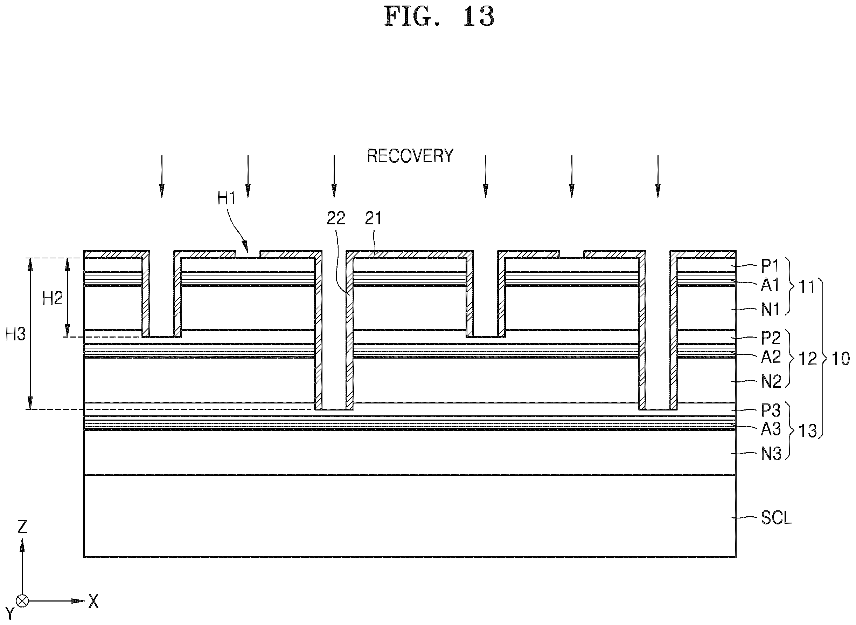

Referring to FIG. 13, the p-type semiconductor characteristics of the p-type semiconductor layers P2 and P3 exposed to the outside may be restored. As described above, the exposed p-type semiconductor layer P2 of the second light-emitting element 12 and the exposed p-type semiconductor layer P3 of the third light-emitting element 13 may be damaged in the process of forming the second hole H2 and the third hole H3 through the plasma etching process. Thus, the exposed p-type semiconductor layer P2 of the second light-emitting element 12 and the exposed p-type semiconductor layer P3 of the third light-emitting element 13 may lose diode junction characteristics or p-type semiconductor characteristics.

A p-type dopant or a p-type semiconductor may be additionally provided to the exposed p-type semiconductor layer P2 of the second light-emitting element 12 and the exposed p-type semiconductor layer P3 of the third light-emitting element 13, and thus the lost p-type semiconductor characteristics may be restored. An area to which the p-type dopant or the p-type semiconductor is additionally provided may be referred to as a p-type semiconductor layer. The process of restoring the p-type semiconductor characteristics may be performed at a relatively high temperature, for example, greater than or equal to about 800 °C while the light-emitting structure 10 is disposed on the sacrificial layer SCL. For example, when the process of restoring the p-type semiconductor characteristics on a driving layer described below is performed, device characteristics of a transistor included in the driving layer may deteriorate.

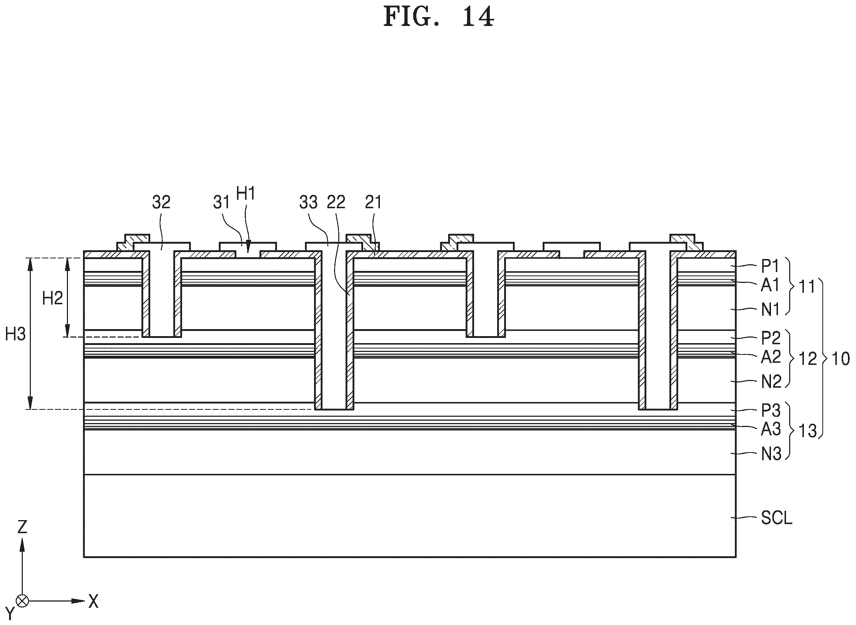

Referring to FIG. 14, the first electrode pattern 30 may be formed on the light-emitting structure 10. That is, the first electrode 31 may be formed on the p-type semiconductor layer P1 of the first light-emitting element 11 exposed through the first hole H1, the second electrode 32 may be formed on the p-type semiconductor layer P2 of the second light-emitting element 12 exposed through the second hole H2, and the third electrode 33 may be formed on the p-type semiconductor layer P3 of the third light-emitting element 13 exposed through the third hole H3. The first electrode 31, the second electrode 32, and the third electrode 33 may all be exposed from the surface of the first light-emitting element 11 and extend onto the first insulating layer 21. The first electrode 31, the second electrode 32, and the third electrode 33 may be formed not to be connected to each other.

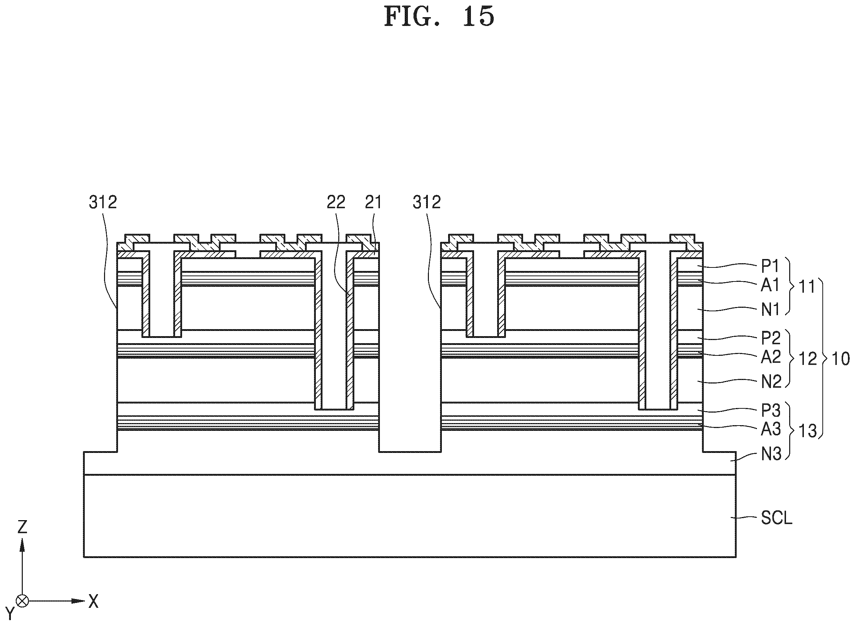

Referring to FIG. 15, the pixel partition 312 may be formed in the light-emitting structure 10. For example, the pixel partition 312 may be formed in a trench shape penetrating the p-type semiconductor layers P3 of the first light-emitting element 11, the second light-emitting element 12, and the third light-emitting element 13, and the active layer A1 of the third light-emitting element 11. The width of the pixel partition 312 may be a distance between the adjacent pixels PX. FIG. 15 illustrates that the pixel partition 312 does not penetrate the n-type semiconductor layer N3 of the third light-emitting element 13, but embodiments are not limited thereto. The pixel partition 312 may penetrate the n-type semiconductor layer N3 of the third light-emitting element 13. The pixel partition 312 does not penetrate the n-type semiconductor layer N3 of the third light-emitting element 13, thereby increasing the durability of the display layer 310.

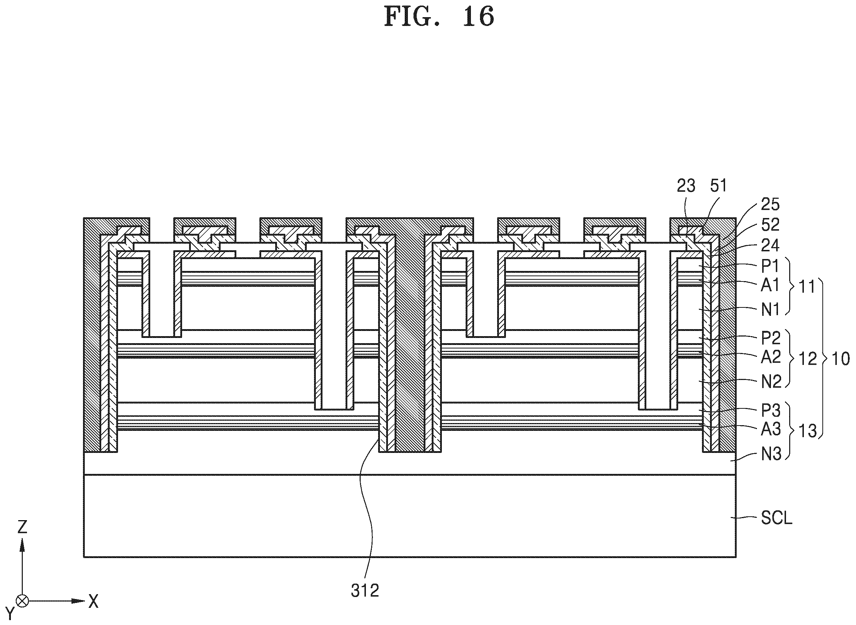

Referring to FIG. 16, the third insulating layer 23, the fourth insulating layer 24, the first reflective layer 51, the second reflective layer 52, and the fifth insulating layer 25 may be formed on the light-emitting structure 10. The third insulating layer 23 and the fourth insulating layer 24 may be respectively formed on the first electrode pattern 30 and a side surface of the pixel partition 312, and the first reflective layer 51 and the second reflective layer 52 may be respectively formed on the third insulating layer 23 and the fifth insulating layer 25. The third insulating layer 23 and the first reflective layer 51 may include holes exposing the first electrode 31, the second electrode 32, and the third electrode 33. The fifth insulating layer 25 may be formed to cover the entire first reflective layer 51 and filling a space in which the pixel partition 312 remains. The fifth insulating layer 25 may also include holes exposing the first electrode 31, the second electrode 32, and the third electrode 33. The third insulating layer 23 and the fourth insulating layer 24 may each include a transparent insulating material, and the fifth insulating layer 25 may include an insulating material of elasticity. In addition, the first reflective layer 51 and the second reflective layer 52 may each include a metal, etc.

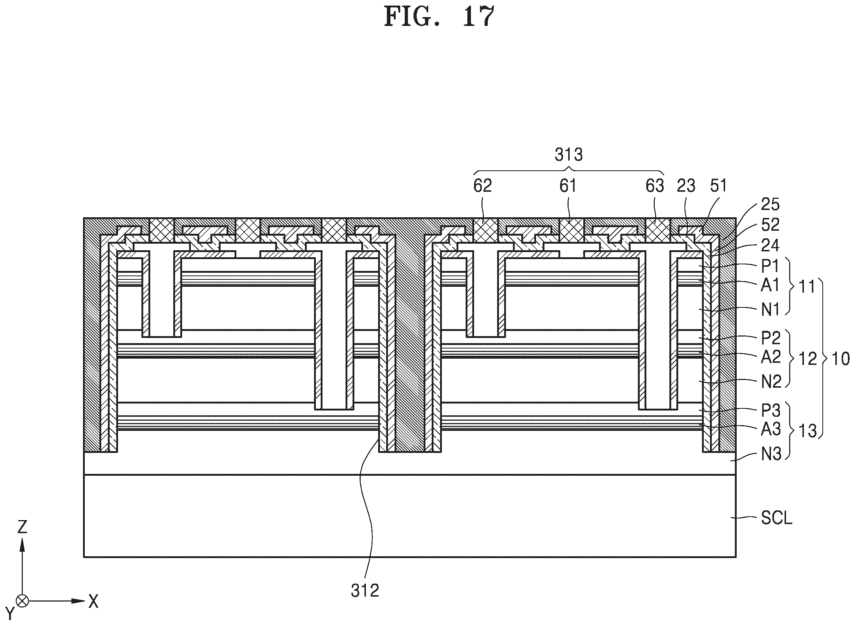

Referring to FIG. 17, the contact electrode pattern 313 including the first contact electrode 61, the second contact electrode 62, and the third contact electrode 63 which are in contact with the first electrode 31, the second electrode 32, and the third electrode 33 may be formed while filling the holes of the fifth insulating layer 25. The first contact electrode 61, the second contact electrode 62, and the third contact electrode 63 may each include a conductive material of elasticity.

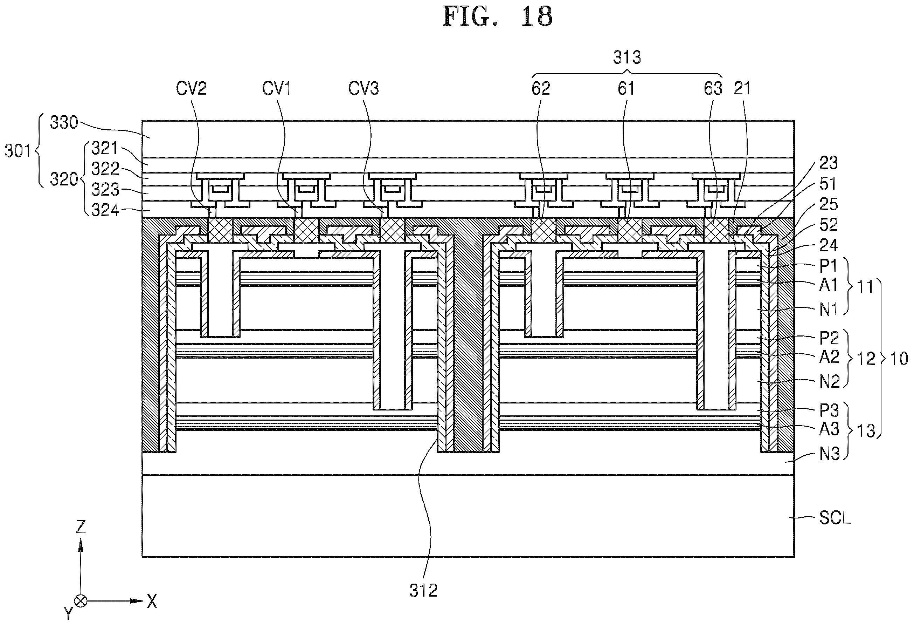

Referring to FIG. 18, the contact electrode pattern 313 may be bonded to the backplane 301. The backplane 301 may include the first transistor TR1, the second transistor TR2, and the third transistor TR3 respectively driving the first light-emitting element 11, the second light-emitting element 12, and the third light-emitting element 13. A first electrode pad, a second electrode pad, and a third electrode pad electrically connected to the first transistor TR1, the second transistor TR2, and the third transistor TR3 respectively are disposed on the surface of the backplane 301. The backplane 301 may be bonded to the light-emitting device 100c such that the first electrode pad, the second electrode pad, and the third electrode pad are connected to the first contact electrode 61, the second contact electrode 62, and the third contact electrode 63 on a one-to-one basis. The backplane 301 may include various types of circuit modules in addition to the first transistor TR1, the second transistor TR2, and the third transistor TR3.

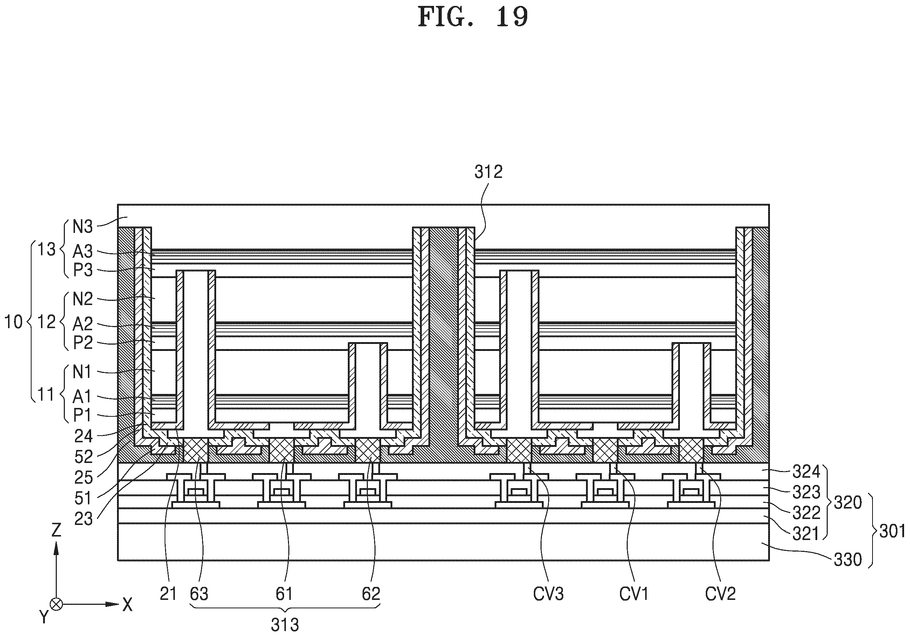

Referring to FIG. 19, the sacrificial layer SCL may be removed from the light-emitting structure 10. After bonding the light-emitting structure 10 and the backplane 301, a vertical direction of the light-emitting structure 10 may be reversed so that the backplane 301 is disposed below the light-emitting structure 10. In addition, the sacrificial layer SCL may be removed from the light-emitting structure 10.

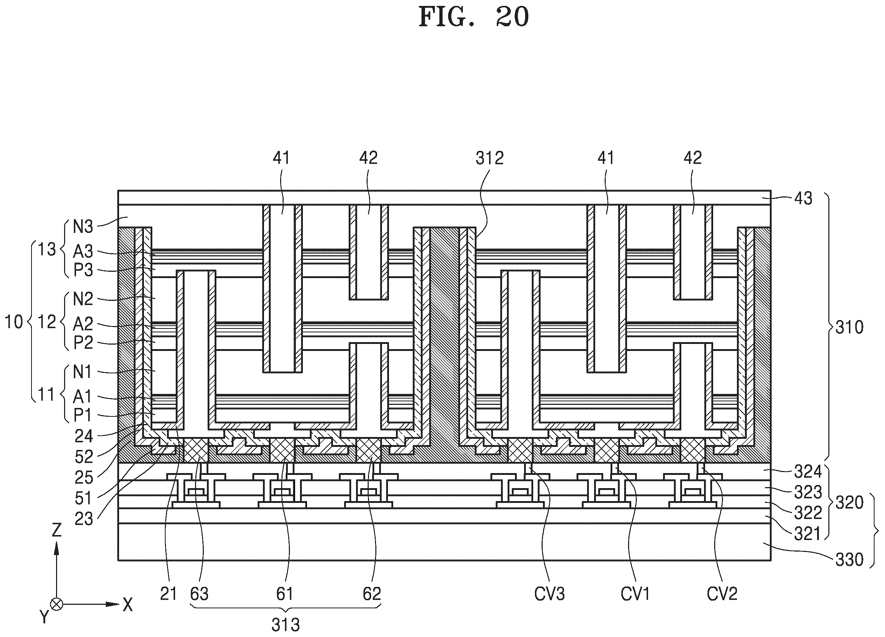

Referring to FIG. 20, the second electrode pattern 40 may be formed on the light-emitting structure 10. First, the fourth hole H4 exposing the n-type semiconductor layer N1 of the first light-emitting element 11 and the fifth hole H5 exposing the n-type semiconductor layer N2 of the second light-emitting element 12 may be formed, and the second insulating layer 22 provided on and surrounding side surfaces of the fourth hole H4 and the fifth hole H5 may be formed. The fourth hole H4 may penetrate the third light-emitting element 13 and the second light-emitting element 12, and the fifth hole H5 may penetrate the third light-emitting element 13, and thus the active areas A2 and A3 of the second light-emitting element 12 and the third light-emitting element 13 may be reduced. Therefore, the widths of the fourth hole H4 and the fifth hole H5 may be small such as less than or equal to about 1 *µ*m or less than or equal to about 0.5 *µ*m in the horizontal direction (X direction and/or Y direction).

The fourth hole H4 and the fifth hole H5 may be performed through a plasma etching process. Even though the fourth hole H4 and the fifth hole H5 are performed through the plasma etching process, the n-type semiconductor layer N1 of the exposed first light-emitting element 11 and the n-type semiconductor layer N2 of the second light-emitting element 12 may maintain the n-type semiconductor characteristics. Therefore, a separate process for restoring the n-type semiconductor characteristics may not be required.

The second electrode pattern 40 may be formed using the fourth hole H4 and the fifth hole H5. For example, the third electrode 41 may be formed on the n-type semiconductor layer N1 of the first light-emitting element 11 exposed through the fourth hole H4, the fourth electrode 42 may be formed on the n-type semiconductor layer N2 of the second light-emitting element 12 exposed through the fifth hole H5, and the sixth electrode 43 may be formed on the exposed n-type semiconductor layer N3 of the third light-emitting element 13. The sixth electrode 43 may be disposed on the n-type semiconductor layer N3 of the third light-emitting element 13 while being connected to the third electrode 41 and the fourth electrode 42. The sixth electrode 43 may cover the entire upper surface of the n-type semiconductor layer N3 of the third light-emitting element 13.

The second electrode pattern 40 may be formed on a surface (i.e., the surface of the third light-emitting element 13) different from a surface (i.e., the surface of the first light-emitting element 11) on which the first electrode pattern 30 is disposed among the surfaces of the light-emitting structure 10 after the light-emitting structure 10 is bonded to the backplane 301. Thus, the active areas of the first light-emitting element 11, the second light-emitting element 12, and the third light-emitting element 13 lost by the holes may remain substantially uniform. In addition, the first electrode pattern 30 and the second electrode pattern 40 may be disposed on different surfaces of the light-emitting structure 10, thereby simplifying a connection wiring between the first electrode pattern 30 and the second electrode pattern 40 and the corresponding circuit modules.

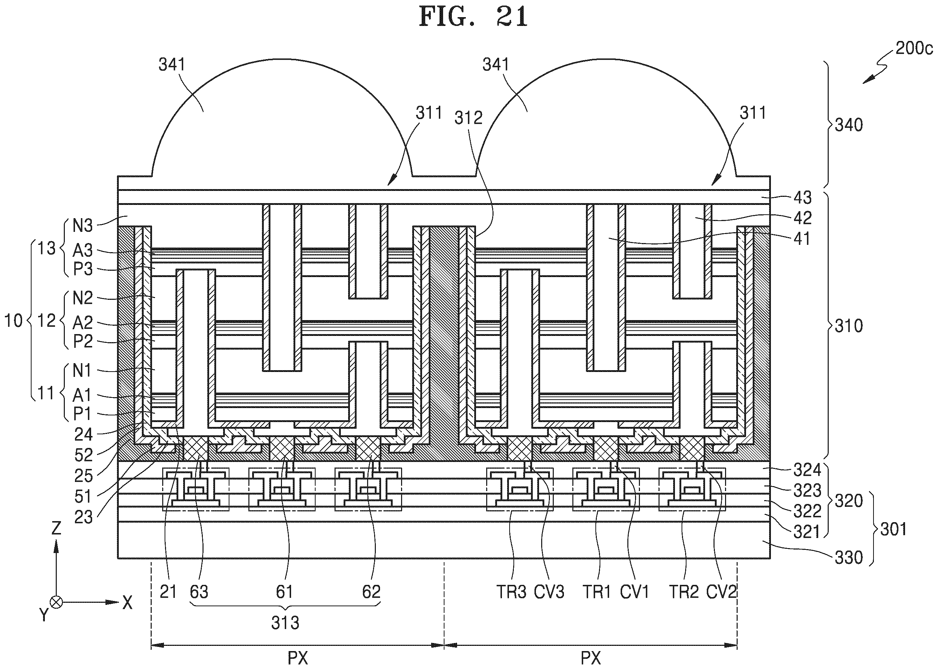

Referring to FIG. 21, the optical layer 340 may be formed on an upper surface of the light-emitting structure 10 (e.g., a surface of the third light-emitting element 13). The optical layer 340 may control a traveling path of light generated by the light-emitting structure 10. The microlens 341 is shown as an optical element in FIG. 21, but embodiments are not limited thereto. The optical element may be a microstructure such as a meta structure.

In the above-described display apparatuses 200, 200a, 200b, and 200c, one pixel providing all of blue light, green light, and red light may be implemented with one light-emitting element 311. Accordingly, the display apparatus 200 may provide an ultra-high resolution image or be implemented as a relatively small display apparatus. The display apparatus 200 may be applicable to various electronic devices having a screen display function.

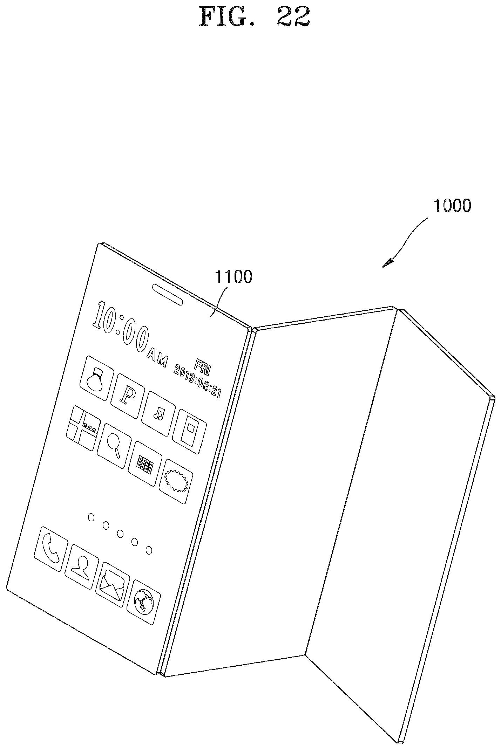

FIG. 22 is a diagram illustrating an example of applying a display apparatus according to one or more embodiments to a mobile device 1000. The mobile device 1000 may include a display apparatus 1100. The display apparatus 1100 may include the display apparatus 200, 200a, 200b, or 200c according to one or more embodiments. The display apparatus 1100 may have a foldable structure, and, for example, be implemented as a multi-foldable display. For example, the mobile device 1000 has been shown to have a folder type display, but may also have a flat type display.

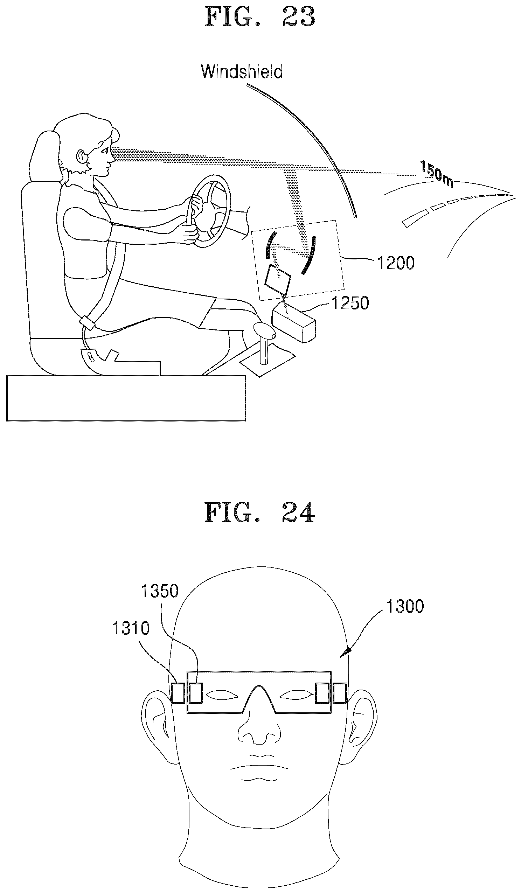

FIG. 23 is a diagram illustrating an example of applying a display apparatus 1250 according to one or more embodiments to a vehicle. The display apparatus 1250 may be a vehicle head-up display apparatus. The head-up display apparatus may include the display apparatus 1250 provided in an area of a vehicle, and at least one light path changing member 1200 that converts an optical path so that a driver may see an image generated on the display apparatus 1250. The display apparatus 1250 may include the display apparatus 200, 200a, 200b, or 200c according to one or more embodiments.

FIG. 24 is a diagram illustrating an example of applying a display apparatus according to one or more embodiments to augmented reality glasses 1300 or virtual reality glasses. The augmented reality glasses 1300 may include a projection system 1310 that forms an image, and at least one element 1350 that guides an image from the projection system 1310 into the user's eye. The projection system 1310 may include the display apparatus 200, 200a, 200b, or 200c according to one or more embodiments.

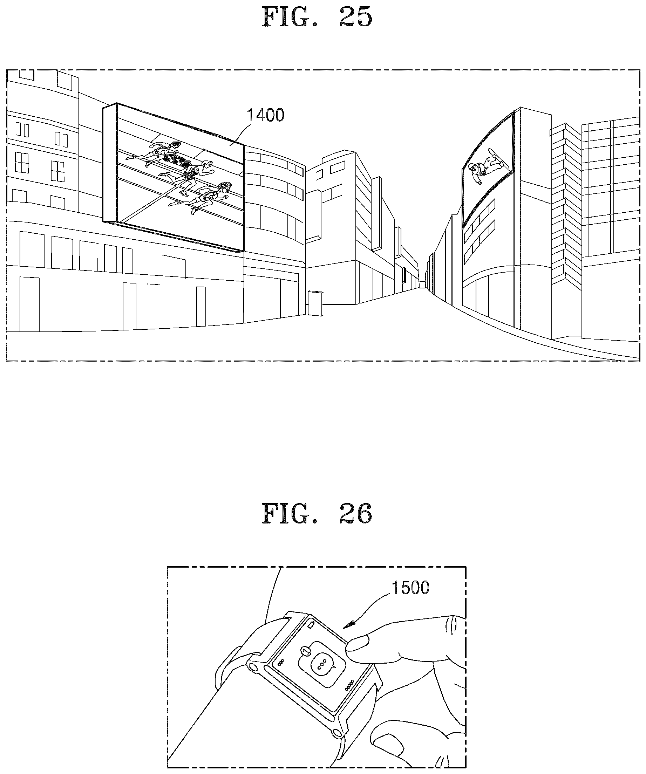

FIG. 25 is a diagram illustrating an example of applying a display apparatus according to one or more embodiments to a relatively large signage 1400. The signage 1400 may be used for outdoor advertisement using a digital information display, and may control advertisement contents through a communication network. The signage 1400 may include the display apparatus 200, 200a, 200b, or 200c according to one or more embodiments.

FIG. 26 is a diagram illustrating an example of applying a display apparatus according to one or more embodiments to a display 1500 of a wearable device. The display 1500 of a wearable device may be applied to the display apparatuses 200, 200a, 200b, and 200c according to one or more embodiments.

The display apparatuses 200, 200a, 200b, and 200c according to one or more embodiments may also be applied to various products such as a rollable TV, a stretchable display, etc.

The light-emitting device according to one or more embodiments may emit light of a plurality of different wavelengths.

In the light-emitting device according to one or more embodiments, a plurality of light-emitting elements is vertically stacked, and thus a relatively wide active layer may be ensured to increase light emission efficiency.

In the light-emitting device according to one or more embodiments, holes for forming an electrode are uniformly distributed on an upper surface and a lower surface of the light-emitting device, thereby uniformly ensuring the active areas of active layers.

When the light-emitting device according to one or more embodiments is used, a display apparatus may be manufactured without a high-level transfer technology.

When the light-emitting device according to one or more embodiments is used, a display apparatus with improved light emission efficiency may be manufactured.

It should be understood that embodiments described herein should be considered in a descriptive sense only and not for purposes of limitation. Descriptions of features or aspects within each embodiment should typically be considered as available for other similar features or aspects in other embodiments.

## Claims

1. A display apparatus comprising:
a display layer comprising a plurality of light-emitting elements; and
a driving layer configured to drive the plurality of light-emitting elements,
wherein at least one light-emitting element of the plurality of light-emitting elements comprises:
a first insulating layer;
a light-emitting structure comprising a first light-emitting element, a second light-emitting element, and a third light-emitting element sequentially and monolithically on the first insulating layer, each of the first light-emitting element, the second light-emitting element, and the third light-emitting element comprising a p-type semiconductor layer, an active layer, and an n-type semiconductor layer and being configured to emit light of different wavelengths,
a first electrode pattern comprising a first electrode, a second electrode, and a third electrode electrically connected to the p-type semiconductor layer of the first light-emitting element, the p-type semiconductor layer of the second light-emitting element, and the p-type semiconductor layer of the third light-emitting element, respectively, and the first electrode, the second electrode, and the third electrode being exposed on a surface of the first insulating layer; and
a second electrode pattern comprising a fourth electrode, a fifth electrode, and a sixth electrode electrically connected to the n-type semiconductor layer of the first light-emitting element, the n-type semiconductor layer of the second light-emitting element, and the n-type semiconductor layer of the third light-emitting element, respectively, and the fourth electrode, the fifth electrode, and the sixth electrode being exposed on a surface of the third light-emitting element.

2. The display apparatus of claim 1, wherein the first electrode penetrates the first insulating layer and contacts the p-type semiconductor layer of the first light-emitting element,
wherein the fourth electrode penetrates the third light-emitting element and the second light-emitting element and contacts the n-type semiconductor layer of the first light-emitting element, and
wherein the first light-emitting element is configured to emit first light based on an electrical signal applied to the first electrode and an electrical signal applied to the fourth electrode; and/or
wherein the second electrode penetrates the first insulating layer and the first light-emitting element and contacts the p-type semiconductor layer of the second light-emitting element,
wherein the fifth electrode penetrates the third light-emitting element and contacts the n-type semiconductor layer of the second light-emitting element, and
wherein the second light-emitting element is configured to emit second light based on an electrical signal applied to the second electrode and an electrical signal applied to the fifth electrode; and/or
wherein the third electrode penetrates the first insulating layer, the first light-emitting element, and the second light-emitting element and contacts the p-type semiconductor layer of the third light-emitting element,
wherein the sixth electrode contacts a surface of the n-type semiconductor layer of the third light-emitting element, and
wherein the third light-emitting element is configured to emit third light based on an electrical signal applied to the third electrode and an electrical signal applied to the sixth electrode.

3. The display apparatus of claim 1 or 2, wherein the first electrode, the second electrode, and the third electrode are not electrically connected to each other.

4. The display apparatus of any one of claims 1-3, wherein the fourth electrode, the fifth electrode, and the sixth electrode are electrically connected to each other; and, preferably, wherein the sixth electrode is on the surface of the third light-emitting element and contacts the fourth electrode and the fifth electrode.

5. The display apparatus of any one of claims 1-4, wherein the light-emitting structure does not comprise a bonding material.

6. The display apparatus of any one of claims 1-5, wherein, in each of the first light-emitting element, the second light-emitting element, and the third light-emitting element, the p-type semiconductor layer, the active layer, and the n-type semiconductor layer are sequentially on the driving layer.

7. The display apparatus of any one of claims 1-6, wherein a wavelength of light emitted by the first light-emitting element is greater than a wavelength of light emitted by the second light-emitting element, and the wavelength of light emitted by the second light-emitting element is greater than a wavelength of light emitted by the third light-emitting element.

8. The display apparatus of any one of claims 1-7, further comprising an optical layer on the display layer, the optical layer being configured to control a traveling path of light emitted from the display layer; and wherein the optical layer optionally comprises a plurality of microlenses corresponding to the plurality of light-emitting elements on a one-to-one basis.

9. The display apparatus of any one of claims 1-8, wherein the display layer comprises:
a first light-emitting device and a second light-emitting device adjacent to each other; and
a pixel partition configured to partition the first light-emitting device and the second light-emitting device.

10. The display apparatus of claim 9, wherein the pixel partition is configured to spatially separate p-type semiconductor layers of a first light-emitting element, a second light-emitting element, and a third light-emitting element included in the first light-emitting device and an active layer of the third light-emitting element, and p-type semiconductor layers of a first light-emitting element, a second light-emitting element, and a third light-emitting element included in the second light-emitting device and an active layer of the third light-emitting element.

11. The display apparatus of claims 9 or 10, wherein an n-type semiconductor layer of a third light-emitting element included in the first light-emitting device and an n-type semiconductor layer of a third light-emitting element included in the second light-emitting device are connected to each other.

12. The display apparatus of any one of claims 9-11, wherein a sixth electrode included in the first light-emitting device and a sixth electrode included in the second light-emitting device are connected to each other and on a same plane.

13. The display apparatus of any one of claims 9-12, further comprising:
a reflective layer on at least a partial area of a side surface of the pixel partition and a surface of the first light-emitting element; and/or
a second insulating layer filling at least a part of an inner space of the pixel partition and a space between the display layer and the driving layer, wherein the second insulating layer comprises at least one of a black matrix material, a resin, or a polymer.

14. A method of manufacturing a display apparatus, the method comprising:
forming, on a sacrificial layer, a light-emitting structure comprising a first light-emitting element, a second light-emitting element, and a third light-emitting element, each of the first light-emitting element, the second light-emitting element, and the third light-emitting element comprising a p-type semiconductor layer, an active layer, and an n-type semiconductor layer and being configured to emit light of different wavelengths;
forming a first insulating layer on the light-emitting structure;
forming a first electrode pattern comprising a first electrode, a second electrode, and a third electrode electrically connected to the p-type semiconductor layer of the first light-emitting element, the p-type semiconductor layer of the second light-emitting element, and the p-type semiconductor layer of the third light-emitting element, respectively, and exposed on a surface of the first insulating layer;
bonding the first electrode pattern on a driving layer configured to drive the light-emitting structure;
removing the sacrificial layer from the light-emitting structure; and
forming a second electrode pattern comprising a fourth electrode, a fifth electrode, and a sixth electrode electrically connected to the n-type semiconductor layer of the first light-emitting element, the n-type semiconductor layer of the second light-emitting element, and the n-type semiconductor layer of the third light-emitting element, respectively, and exposed on a surface of the third light-emitting element.

15. The method of claim 14, further comprising:
forming a pixel partition configured to separate the light-emitting structure into a plurality of pixels.
